(19) Europäisches Patentamt
European Patent Office
Office européen des brevets

(11) EP 4 117 015 A1

(12) EUROPEAN PATENT APPLICATION

(43) Date of publication:
11.01.2023 Bulletin 2023/02

(51) International Patent Classification (IPC):
H01J 37/244 (2006.01)   H01J 37/317 (2006.01)

(21) Application number: 21183803.2

(22) Date of filing: 05.07.2021

(52) Cooperative Patent Classification (CPC):
H01J 37/244; H01J 37/3177; H01J 2237/2443;
H01J 2237/24475; H01J 2237/2448;
H01J 2237/31774

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: ASML Netherlands B.V.
5500 AH Veldhoven (NL)

(72) Inventor: MANGNUS, Albertus Victor Gerardus
5500 AH Veldhoven (NL)

(74) Representative: ASML Netherlands B.V.
Corporate Intellectual Property
P.O. Box 324
5500 AH Veldhoven (NL)

(54) CHARGED PARTICLE DEVICE, DETECTOR, AND METHODS

(57)    A detector assembly for use in a charged particle device for an assessment tool to detect signal particles emitted by a sample in response to a charged particle beam, the detector assembly comprising: a scintillator element configured to generate photons on interaction with signal particles above a first energy threshold; a charge based element configured to detect signal particles below a second energy threshold, wherein the charge based element is positioned so that at least some of the signal particles above a first energy threshold pass through the charged based element to the scintillator element.

## Fig. 14

**Description**

FIELD

The embodiments provided herein generally relate to charged-particle devices, detector assemblies, detector arrangements, and methods.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain data representing characteristics of the material structure of the surface of the sample. The data may be referred to as an image and may be rendered into an image.

Although the data obtained in this way can be useful, there are limitations in the information obtained about the sample from such known electron microscopy techniques. In general, there is a need to obtain additional or alternative information, for example, relating to structures below the surface of the sample and relating to overlay targets.

SUMMARY

It is an object of the present disclosure to provide embodiments that support obtaining information from a sample using charged particles, for example, using backscattered and/or secondary signal particles.

According to an aspect of the invention, there is provided a detector assembly for use in a charged particle device for an assessment tool to detect signal particles emitted by a sample in response to a charged particle beam, the detector assembly comprising: a scintillator element configured to generate photons on interaction with signal particles above a first energy threshold; a charge based element configured to detect signal particles below a second energy threshold, wherein the charge based element is positioned so that at least some of the signal particles above a first energy threshold pass through the charged based element to the scintillator element.

According to an aspect of the invention, there is provided a detector arrangement for use in a multi-beam charged particle device for an assessment tool to detect signal particles emitted by a sample in response to a plurality of charged particle beams, the detector arrangement comprising an array of detector assemblies as described herein, wherein each detector assembly corresponds to a respective charged particle beam.

According to an aspect of the invention, there is provided detector arrangement for use in a multi-beam charged particle device for an assessment tool to detect charged particles emitted by a sample in response to a plurality of charged particle beams on the sample, the detector arrangement comprising: an array of scintillator elements configured to generate photons on interaction with signal particles above an energy threshold; an array of photon detectors configured to detect photons generated by the scintillator elements; and an amplification circuit associated with each photon detector and proximate to the corresponding photon detector, the amplification circuit comprising a Trans Impedance Amplifier and/or an analogue to digital converter.

According to an aspect of the invention, there is provided a charged particle device for an assessment tool to detect signal particles emitted by a sample in response to a charged particle beam, the device comprising: an objective lens configured to project the charged particle beam onto the sample; and a detector assembly as described herein.

According to an aspect of the invention, there is provided a charged particle device for an assessment tool to detect signal particles emitted by a sample in response to a charged particle beam, the device comprising: an objective lens configured to project the charged particle beam onto a sample, wherein an aperture is defined in the objective lens for the charged particle beam; and a detector assembly comprising a scintillator element configured to generate photons on interaction with signal particles and a photon detector configured to detect photons generated by the scintillator element, wherein an aperture is defined in the detector assembly for the charged particle beam.

According to an aspect of the invention, there is provided a charged particle device for an assessment tool to detect signal particles emitted by a sample in response to a plurality of charged particle beams, the device comprising: an objective lens array configured to project a plurality of charged particle beams onto a sample in a multi-beam array; and a detector arrangement as described herein.

According to an aspect of the invention, there is provided a charged particle device for an assessment tool to detect signal particles emitted by a sample in response to a plurality of charged particle beams, the device comprising: an objective lens array configured to project a plurality of charged particle beams onto a sample in a multi-beam array; and a detector arrangement in the path of the charged particle beams, the detector arrangement comprising an array of scintillator elements configured to generate photons on interaction with signal particles above an energy threshold; and an array of photon detectors configured to detect photons generated by the scintillator elements, preferably the array of scintillator elements corresponds to the array of photon detectors so that each scintillator has an associated photon detector.

According to an aspect of the invention, there is provided a method of projecting a beam of charged particles onto a sample so as to detect signal particles emitted from the sample, the method comprising: a) projecting the beam along a primary beam path onto a surface of the sample; and b) simultaneously generating photons at a scintillator element on interaction with signal particles above a first energy threshold and detecting signal particles below a second energy threshold at a charge based element, preferably wherein the detecting and generating occurring in the same detector assembly comprising the charged based element and the scintillator element.

According to an aspect of the invention, there is provided a method of projecting a beam of charged particles onto a sample so as to detect signal particles emitted from the sample, the method comprising: a) projecting the beam along a primary beam path through an aperture of a detector assembly onto a surface of the sample, wherein the detector assembly comprises a scintillator element and a photon detector; and b) generating photons on interaction with signal particles emitted from the sample at the scintillator and detecting the photons generated by the scintillator element at the photon detector.

According to an aspect of the invention, there is provided a method of projecting a plurality of charged particle sub-beams onto a sample so as to detect signal particles emitted from the sample in response to the primary sub-beams, the method comprising: a) projecting the charged particle beams along primary sub-beam paths onto a surface of the sample; and b) simultaneously generating photons on interaction with signal particles above a first energy threshold at a respective scintillator element and detecting signal particles below a second energy threshold at a respective charge based element, preferably wherein the detecting and generating occur in the same detector assembly comprising the charged based element and the scintillator element.

According to an aspect of the invention, there is provided a method of projecting a plurality of charged particle sub-beams onto a sample so as to detect signal particles emitted from the sample, the method comprising: a) projecting the charged particle sub-beams along primary beam paths through at least one aperture of a detector arrangement onto a surface of the sample, wherein the detector arrangement comprises scintillator elements and photon detectors, preferably a respective scintillator element and a respective photon detector for each corresponding sub-beam; and b) generating photons on interaction with signal particles emitted from the sample in response to a sub-beam at the respective scintillator elements and detecting the photons generated by the respective scintillator elements at the respective photon detectors preferably wherein the generating and optionally the detecting occurs in a detector assembly located in the path of an arrangement of the plurality of charged particle sub-beams.

According to an aspect of the invention, there is provided a method of projecting a plurality of charged particle beams onto a sample so as to detect signal particles emitted from the sample, the method comprising: a) projecting the beams along primary beam paths onto a surface of the sample; and b) detecting the signal particles emitted from the sample at a detector arrangement, the detector arrangement comprising: an array of scintillator elements configured to generate photons on interaction with signal particles above an energy threshold; an array of photon detectors configured to detect photons generated by the scintillator elements; and an amplification circuit associated with each photon detector and proximate to the corresponding photon detector, the amplification circuit comprising a Trans Impedance Amplifier and/or an analogue to digital converter.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary charged particle beam inspection apparatus.
FIG. 2 is a schematic diagram illustrating an exemplary multi-beam apparatus that is part of the exemplary charged particle beam inspection apparatus of FIG. 1.

**FIG. 3** is a schematic diagram of an exemplary multi-beam apparatus according to an embodiment.

**FIG. 4** is a schematic cross-sectional view of an objective lens according to an embodiment.

**FIG. 5** is a schematic diagram of an exemplary charged particle optical device according to an embodiment.

**FIG. 6A** and **FIG. 6B** show a bottom view of variations of a detector.

**FIG. 7** is a schematic cross-sectional view of an objective lens comprising detectors located in various positions along a beam path.

**FIG. 8** is a schematic diagram of an exemplary charged particle-optical system comprising a macro collimator and macro scan deflector.

**FIG. 9** is a schematic diagram of an exemplary single beam apparatus according to an embodiment.

**FIGS. 10A, 10B and 10C** are schematic representations of a detector array and an associated cell array according an embodiment, a schematic representation of a cell of the cell array, and a cell of the cell array according to an embodiment.

**FIG. 11** is a circuit diagram of another exemplary amplification circuit according to an embodiment.

**FIG. 12** is a circuit diagram of another exemplary amplification circuit according to an embodiment.

**FIG. 13** is a schematic representation of a cross-section wiring route showing circuit wires and a shielding arrangement according to an embodiment.

**FIG. 14** is a cross-section of a detector assembly according to an embodiment.

**FIG. 15** is a cross-section of a detector assembly according to an embodiment.

**FIG. 16** is a cross-section of a detector assembly according to an embodiment.

**FIG. 17** is a cross-section of a detector assembly according to an embodiment.

The figures are schematic. The schematic diagrams and views show the components described below. However, the components depicted in the figures are not to scale. Relative dimensions of components in drawings are exaggerated for clarity. Within the following description of drawings the same or like reference numbers refer to the same or like components or entities, and only the differences with respect to the individual embodiments are described.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused primary beams, i.e. a multi-beam, of primary electrons. The component beams of the multi-beam may be referred to as sub-beams or beamlets or an array of primary beams. A multi-beam can scan different parts of a sample simultaneously. A multi-beam inspection apparatus can therefore inspect a sample at a much higher speed than a single-beam inspection apparatus. An implementation of a known multi-beam inspection apparatus is described below.

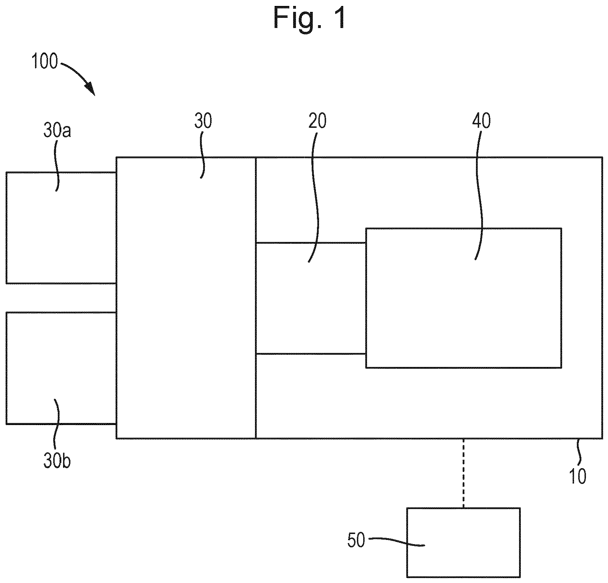

Reference is now made to **FIG. 1,** which is a schematic diagram illustrating an exemplary charged particle beam inspection apparatus 100. The charged particle beam inspection apparatus 100 of **FIG. 1** includes a main chamber 10, a load lock chamber 20, an charged particle beam tool 40 (which may otherwise be referred to as an electron beam tool), an equipment front end module (EFEM) 30 and a controller 50. The charged particle beam tool 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle beam tool 40 by which it may be inspected. An charged particle beam tool 40 may comprise a multi-beam charged particle -optical apparatus.

The controller 50 is electronically connected to the charged particle beam tool 40. The controller 50 may be a processor (such as a computer) configured to control the charged particle beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing a charged particle beam inspection tool, it should be noted that aspects of the disclosure in their broadest sense are not limited to a chamber housing an charged particle beam inspection tool. Rather, it is appreciated that the foregoing principles may also be applied to other tools and other arrangements of apparatus, that operate under the second pressure.

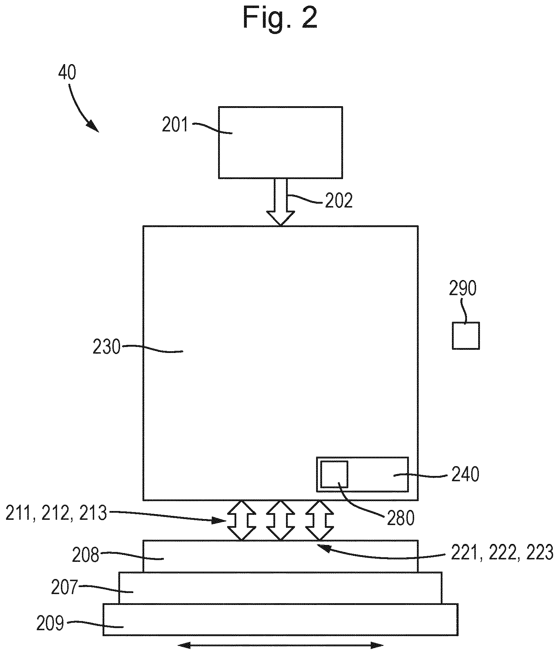

Reference is now made to **FIG. 2,** which is a schematic diagram illustrating an exemplary charged particle beam tool 40 including a multi-beam inspection tool that is part of the exemplary charged particle beam inspection apparatus 100 of **FIG. 1.** The multi-beam charged particle beam tool 40 (also referred to herein as apparatus 40) comprises an charged particle source 201, a projection apparatus 230, a motorized stage 209, and a sample holder 207. The charged particle source 201 and projection apparatus 230 may together be referred to as an illumination apparatus. The sample holder 207 is supported by motorized stage 209 so as to hold a sample 208 (e.g., a substrate or a mask) for inspection. The multi-beam charged particle beam tool 40 further comprises a detector array 240 (e.g. an electron detection device).

The controller 50 may be connected to various parts of the charged particle beam inspection apparatus 100 of **FIG. 1.** The controller 50 may be connected to various parts of the charged particle beam tool 40 of **FIG. 2,** such as the charged particle source 201, the detector array 240, the projection apparatus 230, and the motorized stage 209. The controller 50 may perform various data, image and/or signal processing functions. The controller 50 may also generate various control signals to govern operations of the charged particle beam inspection apparatus 100, including the charged particle multi-beam apparatus. The controller 50 may control the motorized stage 209 to move sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

The charged particle source 201 may comprise a cathode (not shown) and an extractor or anode (not shown). During operation, the charged particle source 201 is configured to emit charged particle (e.g. electrons) as primary charged particles from the cathode. The primary charged particles are extracted or accelerated by the extractor and/or the anode to form a primary charged particle beam 202. The charged particle source 201 may comprise multiple sources, such as described in EP20184161.6, which is hereby incorporated by reference at least with respect to the multiple sources and how they relate to multiple columns and their associated charged particle-optics.

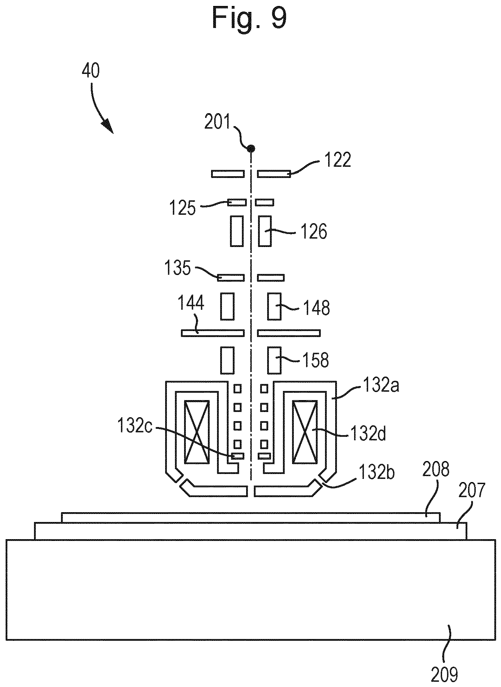

The projection apparatus 230 is configured to convert the primary charged particle beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets. Furthermore, although the present description and figures relate to a multi-beam system, a single beam system may be used instead in which the primary charged particle beam 202 is not converted into multiple sub-beams. This is described further below in relation to **FIG. 9** , but it will be noted that the sub-beams may be interchangeable with a single primary charged particle beam 202.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, signal charged particles (e.g. electrons) are generated (i.e. emitted) from the sample 208 which include secondary signal particles and backscatter signal particles. The signal particles emitted from the sample, e.g. secondary electrons and backscatter electrons, may otherwise be referred to as charged particles, e.g. secondary charged particles and backscatter charged particles. Signal beams are formed of signal particles emitted from the sample. It will generally be understood that any signal beams emitted from the sample 208 will travel in a direction with at least a component substantially opposite to the charged particle beams (i.e. the primary beams), or will have at least a component of direction which is opposite to the direction of the primary beams. Signal particles, which are emitted by the sample 208 may also pass through the electrodes of the objective lens and would also be affected by the field.

The secondary signal particles typically have charged particle energy $\leq 50$ eV. Actual secondary signal particles can have an energy of less than 5 eV, but anything beneath 50 eV is generally treated as a secondary signal particle. Backscatter signal particles typically have energy between 0 eV and the landing energy of the primary sub-beams 211, 212, and 213. As signal particles detected with an energy of less than 50 eV are generally treated as a secondary signal particles, a proportion of the actual backscatter signal particles will be counted as secondary signal particles. The secondary signal particles may more specifically be referred to, and are interchangeable with, secondary electrons. The backscatter signal particles may more specifically be referred to, and are interchangeable with, backscatter electrons. The skilled person would understand that the backscatter signal particles may more generally be described as secondary signal particles. However, for the purposes of the present disclosure, the backscatter signal particles are considered to be different from the secondary signal particles, e.g. having higher energies. In other words, the secondary signal particles will be understood to be particles having kinetic energy $\leq 50$ eV when emitted from the sampled and the backscatter signal particles will be understood to be particles having kinetic energy higher than 50 eV when emitted from the sample. In practice, the signal particles may be accelerated before being detected and thus, the energy range associated with the signal particles may be slightly higher. For example, the secondary signal particles will be understood to be particles having kinetic energy $\leq 200$ eV when detected at a detector and the backscatter signal particles will be understood to be particles having kinetic energy higher than 200 eV when detected at a detector. It is noted that the 200 eV value may vary depending on the extent of acceleration of the particles, and may for example be approximately 100 eV or 300 eV. Secondary signal particles having such values are still considered to have sufficient energy different with respect to the backscatter signal particles.

The detector array 240 is configured to detect (i.e. capture) signal particles emitted from the sample 208. The detector array 240 is configured to generate corresponding signals which are sent to a signal processing system 280, e.g. to construct images of the corresponding scanned areas of sample 208. The detector array 240 may be incorporated into the projection apparatus 230. The detector array may otherwise be referred to as a sensor array, and the terms "detector" and "sensor" and "sensor unit" are used interchangeably throughout the application.

The signal processing system 280 may comprise a circuit (not shown) configured to process signals from the detector array 240 so as to form an image. The signal processing system 280 could otherwise be referred to as an image processing system or a data processing system. The signal processing system may be incorporated into a component of the multi-beam charged particle beam tool 40 such as the detector array 240 (as shown in **FIG. 2**). However, the signal processing system 280 may be incorporated into any components of the inspection apparatus 100 or multi-beam charged particle beam tool 40, such as, as part of the projection apparatus 230 or the controller 50. The signal processing system 280 could be located outside of the structure that includes the main chamber which is shown in **FIG. 1.** The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary signal particles. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

Known multi-beam systems, such as the charged particle beam tool 40 and charged particle beam inspection apparatus 100 described above, are disclosed in US2020118784, US20200203116, US 2019/0259570 and US2019/0259564 which are hereby incorporated by reference.

In known single-beam systems, different signals (e.g. from secondary signal particles and/or backscatter signal particles) might theoretically be detected. Multi-beam systems are known and are beneficial as the throughput can be much higher than when using single-beam systems, e.g. the throughput of a multi-beam inspection system may be 100 times higher than the throughput in a single-beam inspection system.

In known multi-beam systems, an array of primary sub-beams of charged particles at a relatively high energy are targeted with a final deceleration step in order to land on a sample at a relatively low landing energy for detection of secondary signal particles as mentioned above. However, in practice, it has not generally been possible to use multi beam inspection in combination with backscatter detection, or at least by direct backscatter detection, i.e. presently known multi-beam systems rely primarily on detection of secondary signal particles. However, there are limitations in the information which can be obtained solely from secondary signal particles. Backscatter signal particles provide information about structures below the surface, such as buried defects. Additionally, backscatter signals can be used to measure overlay targets.

As described above, backscatter signal particles have a large range of energies, typically between 0 eV and the landing energy. The backscatter signal particles have a large range in energy (for example up to the landing energy of the primary beam) and wide angle of emitted backscatter signal particles. Secondary signal particles typically have a more restricted energy range and tend to be distributed around an energy value. The large energy range and wide angle of emitted backscatter signal particles results in cross-talk in a multi-beam system. Cross-talk occurs when backscatter signal particles resulting from one primary sub-beam are detected at a detector assigned to a different sub-beam. Cross-talk generally occurs very close to the sample 208, i.e. proximate the sample onto which the primary beam is projected. Due to the cross-talk, previously known multi-beam assessment tools have not been able to effectively image backscatter signals. As a consequence, it has not been possible to increase the throughput for backscattered detection by using multi-beam systems.

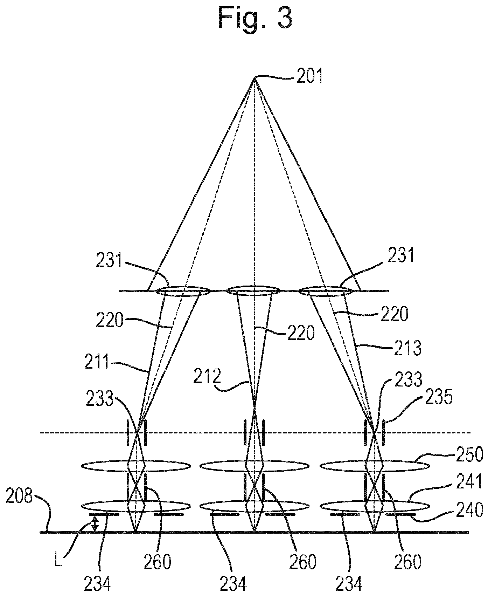

Components of an assessment tool 40 which may be used in the present invention are described below in relation to **FIG. 3** which is a schematic diagram of an assessment tool 40. The charged particle assessment tool 40 of **FIG. 3** may correspond to the multi-beam charged particle beam tool (also referred to herein as apparatus 40).

The charged particle source 201 directs charged particles (e.g. electrons) toward an array of condenser lenses 231 (otherwise referred to as a condenser lens array) forming part of the projection system 230. The charged particle source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect. More generally, the condenser lens array 231 may have two or more plate electrodes each with an array of apertures that are aligned. Each plate electrode array is mechanically connected to, and electrically isolated from, an adjacent plate electrode array by an isolating element, such as a spacer which may comprise ceramic or glass. The condenser lens array may be connected and/or spaced apart from an adjacent charged particle-optical element, preferably an electrostatic charged particle-optical element, by an isolating element such as a spacer as described elsewhere herein.

The condenser lenses may be separated from a module containing the objective lenses (such as an objective lens array assembly as discussed elsewhere herein). In a case where the potential applied on a bottom surface of the condenser lenses is different than the potential applied on the top surface of the module containing the objective lenses an isolating element (e.g. a spacer) is used to space apart the condenser lenses and the module containing the objective lenses. In a case where the potential is equal then a conductive element can be used to space apart the condenser lenses and the module containing the objective lenses.

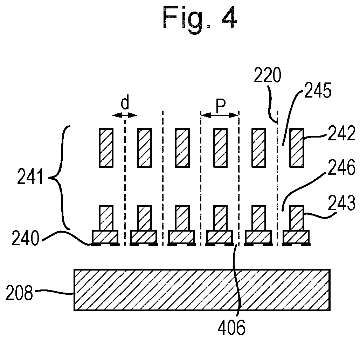

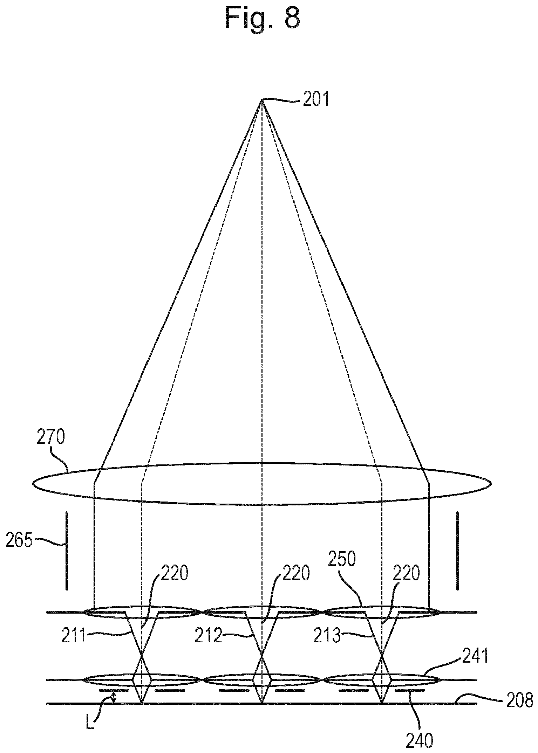

Each condenser lens 231 in the array directs a primary beam of charged particles into a respective sub-beam 211, 212, 213 which is focused at a respective intermediate focus down beam of the condenser lens array. The respective sub-beams are projected along respective sub-beam paths 220. The sub-beams diverge with respect to each other. The sub-beam paths 220 diverge down beam of the condenser lenses 231. In an embodiment, deflectors 235 are provided at the intermediate focuses. The deflectors 235 are positioned in the sub-beam paths at, or at least around, the position of the corresponding intermediate focusses 233 or focus points (i.e. points of focus). The deflectors are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Down beam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. The collimator may comprise a macro collimator 270, instead of, or in addition to the deflectors 235. Thus, the macro-collimator 270 described below in relation to **FIG. 8** may be provided with the features of **FIG. 3** or **FIG. 4.** This is generally less preferred than providing the collimator array as deflectors 235.

Below (i.e. down beam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

In further detail, it is desirable to use the control lens array 250 to determine the landing energy. However, it is possible to use in addition the objective lens array 240 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location, for example in, on or otherwise associated with the objective lens. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array electrodes may be spaced a few millimeters (e.g. 3mm) apart. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned up-beam of the objective lens array 241. Up-beam may be defined as being closer to the source 201. Up-beam may otherwise be defined as further from the sample 208. The control lens array 250 may be in the same module as an objective lens array 241, i.e. forming an objective lens array assembly or objective lens arrangement, or it may be in a separate module. In this case, the arrangement may be described as four or more lens electrodes that are plates. In the plates are defined apertures, for example as aperture arrays, that are aligned with a number of sub-beams in a corresponding beam array. The electrodes may be grouped into two or more electrodes, for example to provide a control electrode group, and an objective electrode group. In an arrangement the objective electrode group has at least three electrodes and the control electrode group has at least two electrodes. Alternatively, if the control lens array 250 and the objective lens array 240 are separate, the spacing between the control lens array 241 and the objective lens array 250 (i.e. the gap between lower electrode of the control lens array 250 and the upper electrode of the objective lens 241) can be selected from a wide range, e.g. from 2 mm to 200 mm or more. A small separation makes alignment easier whereas a larger separation allows a weaker lens to be used, reducing aberrations.

Each plate electrode of the control lens array 250 is preferably mechanically connected to, and electrically separated from, an adjacent plate electrode array by an isolating element, such as a spacer which may comprise ceramic or glass. Each plate electrode of the objective lens array is preferably mechanically connected to, and electrically separated from, an adjacent plate electrode array by an isolating element, such as a spacer which may comprise ceramic or glass. The isolating element may otherwise be referred to as an insulating structure, and may be provided to separate any adjacent electrodes provided, such as in the objective lens array 240, the condenser lens array (as depicted in **FIG. 3**) and/or the control lens array 250. If more than two electrodes are provided, multiple isolating elements (i.e. insulating structures) may be provided. For example, there may be a sequence of insulating structures.

The control lens array 250 comprises a control lens for each sub-beam 211, 212, 213. A control lens adds optical degrees of freedom to the function of the associated objective lens. A control lens may comprise of one or more electrode or plates. The addition of each electrode may provide a further degree of freedom of the control of the charged particle-optical function of the associated objective lens. In an arrangement the function of the control lens array 250 is to optimize the beam opening angle with respect to the demagnification of the beam and/or to control the beam energy delivered to the objective lenses 234, each of which directs a respective sub-beam 211, 212, 213 onto the sample 208. The objective lenses may be positioned at or near the base of the charged particle-optical system. More specifically, the objective lens array may be positioned at or near the base of the projection system 230. The control lens array 250 is optional, but is preferred for optimizing a sub-beam upbeam of the objective lens array.

For ease of illustration, lens arrays are depicted schematically herein by arrays of oval shapes (as shown in **FIG. 3**). Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally, an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

The objective lens array 241 may comprise at least two electrodes in which are defined aperture arrays. In other words, the objective lens array comprises at least two electrodes with a plurality of holes or apertures. Adjacent electrodes of the objective lens array 241 are spaced apart from each other along the sub-beam paths. The distance between adjacent electrodes along the beam path, in which an insulating structure might be positioned as described below, is smaller than the size of an objective lens (along the beam path, i.e. between the most upbeam and most down beam electrode of the objective lens array). **FIG. 4** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of sub-beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates.

The aperture arrays 245, 246 of the objective lens array 241 may consist of a plurality of apertures, preferably with substantially uniform diameters, d. However there may be some variation for optimizing aberration correction as described in EP Application 20207178.3 filed on 12 November 2020 which is herein incorporated by reference at least with respect to corrections achieved by varying aperture diameter. The diameter, d, of the apertures in at least one electrode may be less than approximately 400 $\mu$m. Preferably, the diameter, d, of the apertures in at least one electrode is between approximately 30 to 300 $\mu$m. Smaller aperture diameters may provide larger detectors of the detector array 240 for a given aperture pitch, improving the chance of capturing backscatter signal particles. Thus the signal for the backscatter signal particles may improve. However, having apertures that are too small risk inducing aberrations in the primary sub-beams. The plurality of apertures in an electrode may be spaced apart from each other by a pitch, P. The pitch, P, is defined as the distance from the middle of one aperture to the middle of an adjacent aperture. The pitch between adjacent apertures in at least one electrode may be less than approximately 600 μm. Preferably, the pitch between adjacent apertures in at least one electrode is between approximately 50 μm and 500 μm. Preferably, the pitch between adjacent apertures on each electrode is substantially uniform. The values for the diameter and/or pitch described above can be provided in at least one electrode, multiple electrodes, or all electrodes in an objective lens array. Preferably, the dimensions referred to and described apply to all electrodes provided in an array of objective lenses.

The objective lens array 241 may comprise two or three electrodes or may have more electrodes (not shown). An objective lens array 241 having only two electrodes can have fewer aberrations, e.g. a lower aberration risk and/or impact, than an objective lens array 241 having more electrodes. A three-electrode objective lens can have greater potential differences between the electrodes and so enable a stronger lens. Additional electrodes (i.e. more than two electrodes) provide additional degrees of freedom for controlling the charged particle trajectories, e.g. to focus secondary signal particles as well as the incident beam. A benefit of two electrode lens over an Einzel lens is that the energy of an in-coming beam is not necessarily the same as an out-going beam. Beneficially the potential differences on such a two electrode lens array enables it to function as either an accelerating or a decelerating lens array. The objective lens array 241 can be configured to demagnify the charged particle beam by a factor greater than 10, desirably in the range of 50 to 100 or more. Each element in the objective lens array 240 may be a micro-lens operating a different sub-beam or group of sub-beams in the multi-beam.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

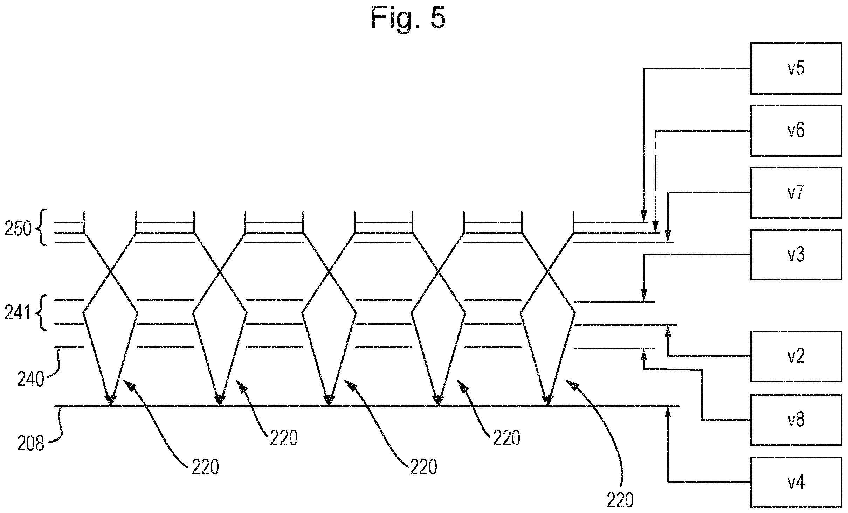

**FIG. 5** is an enlarged schematic view of multiple objective lenses of the objective lens array 241 and multiple control lenses of the control lens array 250. As described in further detail below, the lens arrays can be provided by electrodes with a selected potential applied to the electrode by a voltage source, i.e. electrodes of the arrays are connected to respective potential sources. In **FIG. 5,** multiple lenses of each of the control lens array 250, the objective lens array 241 and the detector array 240 are depicted, for example, with any of sub-beams 211, 212, 213 passing through the lenses as shown. Although **FIG. 5** depicts five lenses, any appropriate number may be provided; for example, in the plane of the lenses, there may be 100, 1000 or of the order of 10,000 lenses. Features that are the same as those described above are given the same reference numerals. For conciseness, the description of these features provided above applies to the features shown in **FIG. 5.** The charged particle optical device may comprise one, some or all of the components shown in **FIG. 5.** Note that this figure is schematic and may not be to scale. For example, in a non-limited list: the sub-beams may be narrower at the controller array 250 than at the objective lens array 241; the detector array 240 may be closer to the electrodes of the objective lens array 241 than the electrodes of the objective lens array 241 are to each other; and a focus point of each sub-beam between the controller lens array 250 may be closer to the objective lens array 241 than depicted. Spacing between electrodes of the control lens array 250 may be larger than spacing between electrodes of the objective lens array 241 as shown in **FIG. 5,** but this is not a necessity.

As shown in **FIG. 5,** the sub-beams may be parallel on entry into the control lens array 250, as shown in **FIG. 3.** However, the same components of **FIG. 5** may be used in a configuration as shown in **FIG. 8,** in which case, the sub-beams may be separated (or generated) from a beam from a source further down beam. For example, the sub-beams may be defined by a beam limiting aperture array which may be part of a lens arrangement such as an objective lens array, a control lens array, or any other lens element that may be associated with an objective lens array for example that is part of an objective lens array assembly. As depicted in **FIG. 8,** the sub-beams may be separated from the beam from the source by a beam limiting aperture array that may be part of the control lens array 250 as a most up beam electrode of the control lens array 250.

Voltage sources V3 and V2 (which may be provided by individual electric power sources, or may all be supplied by electric power source 290) are configured to apply potentials to the upper and lower electrodes of the objective lens array 241 respectively. The upper and lower electrodes may be referred to as an up-beam electrode 242 and a down-beam electrode 243 respectively. Voltage sources V5, V6, V7 (which may be provided by individual electric power sources, or may all be supplied by electric power source 290) are configured to apply potentials to the first, second and third electrodes of the control lens array 250 respectively. A further voltage source V4 is connected to the sample to apply a sample potential. A further voltage source V8 is connected to the detector array to apply a detector array potential. Although the control lens array 250 is shown with three electrodes, the control lens array 250 may be provided with two electrodes (or more than three electrodes). Although the objective lens array 240 is shown with two electrodes, the objective lens array 240 may be provided with three electrodes (or more than three electrodes). For example, a middle electrode may be provided in the objective lens array 241 between the electrodes shown in **FIG. 5** with a corresponding voltage source, V1 (not shown).

Desirably, the potential V5 of the uppermost electrode of the control lens array 250 is maintained the same as the potential of the next charged particle-optic element up-beam of the control lens (e.g. deflectors 235). The potential V7 applied to the lower electrode of the control lens array 250 can be varied to determine the beam energy. The potential V6 applied to the middle electrode of the control lens array 250 can be varied to determine the lens strength of the control lens and hence control the opening angle and demagnification of the beam. It should be noted that even if the landing energy does not need to be changed, or is changed by other means, the control lens can be used to control the beam opening angle. The position of the focus of a sub-beam is determined by the combination of the actions of the respective control lens array 250 and the respective objective lens 240.

The detector array 240 (which may otherwise be referred to as an array of detectors) comprises a plurality of detectors. Each detector is associated with a corresponding sub-beam (which may otherwise be referred to as a beam or primary beam). In other words, the arrays of detectors (i.e. the detector array 240) and sub-beams correspond. Each detector may be assigned to a sub-beam. The array of detectors may correspond with the array of objective lenses. In other words, the array of detectors may be associated with the corresponding array of objective lenses. A detector array 240 is described below. However, any reference to detector array 240 could be replaced with a single detector (i.e. at least one detector) or multiple detectors as appropriate. The detectors may otherwise be referred to as of detector elements 405 (e.g. sensor elements such as capture electrodes). The detectors may be any appropriate type of detector.

The detector array 240 may be positioned at a position along the primary beam path at any location between an upper beam position and a lower beam position along the beam path. The upper beam position is above the objective lens array and optionally any associated lens arrays such as a control lens array (i.e. up beam of an objective lens array assembly). The lower beam position is down beam of the objective lens array. In an arrangement the detector array may be an array that is up beam of the objective lens array assembly. The detector array may be associated with any electrode of the objective lens array assembly. Reference hereafter of a detector in association with an electrode of the objective lens array may correspond to an electrode of the objective lens array assembly, except for the most down beam surface of the most down beam electrode of the objective lens array, unless stated explicitly otherwise.

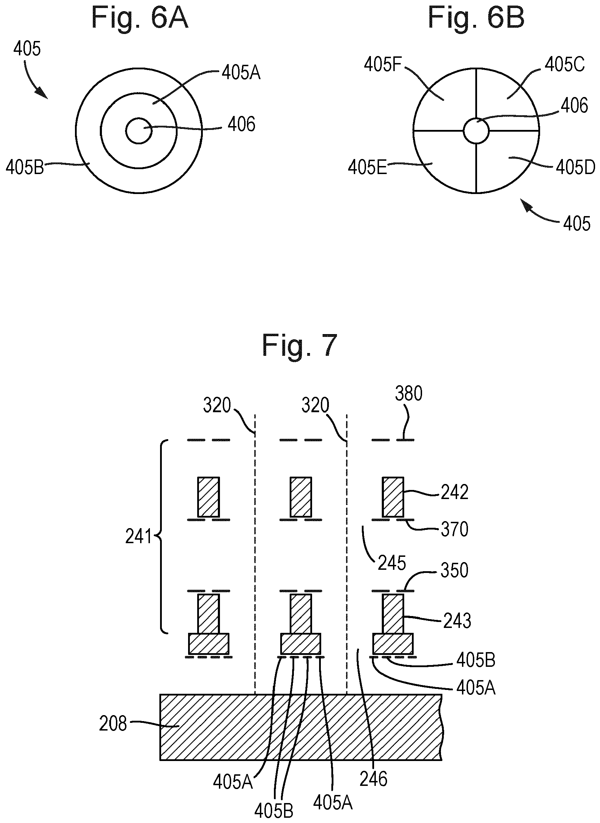

In an arrangement the detector array 240 may be positioned between the control lens array 250 and the sample 208. The detector array 240 may be positioned between the objective lenses 234 and the sample 208, as shown in **FIG. 4** and **FIG. 5.** Although this may be preferable, the detector array 240 could be provided in additional or alternative locations, such as those depicted in **FIG. 7.** Multiple detector arrays may be provided in a variety of locations, e.g. as in **FIG. 7.** The signal particles, including backscatter signal particles may be detected directly from the surface of the sample 208. Thus, the backscatter signal particles may be detected without having to be converted, for example, into another type of signal particle such a secondary signal particle which may be easier to detect. Thus, the backscatter signal particles may be detected by the detector array 240 without encountering, e.g. hitting, any other components or surfaces between the sample 208 and the detector array 241.

The detector array is positioned between the objective lens array 241 and the sample 208. The detector array 240 is configured to be proximate the sample. The detector array 240 may be proximate the sample so as to detect backscatter signal particles from the sample 208. The detector being proximate the sample enables the risk of cross-talk in detection of backscatter signal particles generated by sub-beams which correspond to another detector in the detector array to be reduced if not avoided. In other words, the detector array 240 is very close to the sample 208. The detector array 240 may be within a certain distance of the sample 208, as described below. The detector array 240 may be adjacent to the sample 208. The at least one detector may be positioned in the device so as to face the sample. That is the detector may provide a base to the device. The detector as part of the base may face a surface of the sample. This may be beneficial in positioning the at least one detector in a location in which the at least one detector is more likely to detect backscatter particles than secondary particles. For example, the at least one detector array may be provided on an output side of the objective lens array 241. The output side of the objective lens array 241 is the side on which the sub-beams are output from the objective lens array 241, i.e. the bottom or downbeam side of the objective lens array in the configuration shown in **FIG. 3, FIG. 4** and **FIG. 5.** In other words, the detector array 240 may be provided downbeam of the objective lens array 241. The detector array may be positioned on, or adjacent to, the objective lens array. The detector array 241 may be an integral component of the objective lens array 241. The detector and objective lens may be part of the same structure. The detector may be connected to the lens by an isolating element or directly to an electrode of the objective lens. Thus, the at least one detector may be part of an objective lens assembly comprising at least the objective lens array and the detector array. If the detector array is an integral component of the objective lens array 241, the detector array 240 may be provided at the base of the objective lens array 241. In an arrangement the detector array 240 may be integral to the most-down-beam positioned electrode of the objective lens array 241.

Ideally, the detector array is as close as possible to the sample. The detector array 240 is preferably very close to the sample 208 such that there is a proximity focus of backscatter signal particles at the detector array. As previously described, the energy and angular spread of the backscatter signal particles is generally so large that it is difficult (or impossible in known prior art systems) to keep the signals from neighboring sub-beams separated. However, the proximity focus means that backscatter signal particles can be detected at a relevant one of the detectors without cross-talk (i.e.

interference from neighboring sub-beams) in the first aspect. Of course, there is a minimum distance between the sample 208 and the detector array 240. However, it is preferable to reduce this distance as much as possible. Certain configurations may benefit from reducing the distance even more than others.

Preferably, a distance 'L' as shown in **FIG. 3,** between the detector array 240 and the sample 208 is less than or equal to approximately 50 $\mu$m, i.e. the detector array 240 is positioned within approximately 50 $\mu$m from the sample 208. Although is generally preferably that the distance L is small (e.g. between around 10 to 65 microns), as this can improve detector efficiency and/or reduce cross-talk, the distance may be greater. For example, the distance L may be approximately 100 microns or less, or approximately 200 microns or less. The distance L is determined as the distance from a surface of the sample 208 facing the detector array 240 and a surface of the detector array 241 facing the sample 208. Providing a distance of approximately 50 $\mu$m or less is beneficial in that cross-talk between backscatter signal particles can be avoided or minimized. Theoretically, there may be a lower limit of how close the sample 208 and the detector array 240 can be whilst allowing these components to move relative to each other and this may mean that the distance L might be more than approximately 5 $\mu$m or 10 $\mu$m. For example, a distance L of approximately 50 $\mu$m or less may be used whilst still allowing relatively reliable control of the device as shown as part of the tool in **FIG. 3.** A distance L of approximately 30 $\mu$m or less may be preferable for other configurations, such as those shown and described in relation to **FIG. 8** below. A preferred range of the distance L between the detector array 240 and the sample 208 may be between approximately 5 $\mu$m to 200 $\mu$m, or preferably between approximately 5 $\mu$m to 100 $\mu$m, or preferably between approximately 5 $\mu$m to 50 $\mu$m, or preferably between approximately 10 $\mu$m to 50 $\mu$m, or preferably between approximately 30 $\mu$m to 50 $\mu$m. In an arrangement the detector array 240 may be actuatable relative to the objective lens array 241, i.e. to vary the distance L, for example to substantially maintain a distance between the sample and the detector array L. It is noted that the distance L described here is for a multi-beam system as shown in **FIG. 3** (or **FIG. 8**). The same distance may be used in a single beam device, e.g. as shown in **FIG. 9,** although the distance L may be larger for the single beam device.

The backscatter signal particles are emitted from the sample 208 with a very large energy spread, and typically with an angular spread following a cosine distribution which may take the appearance in three dimensions of a cone. The further the distance from sample 208 to the detector array 240, the larger the cone of the emitted beam becomes. It will be understood that the backscatter signal particles can have all angles. The cone of the emitted beam is the solid angle assignable to the detector associated with a respective beam, so that this solid angle is larger with greater proximity of the sample and the detector. Because of the very large energy spread it may not be possible to image the backscatter signal particles coming from the different sub-beams onto a detector without introducing significant cross talk. The solution is to place the detector in close proximity to the substrate, and choose the pitch of the sub-beams such that the backscatter signal particle signals of the neighbouring sub-beams to not overlay.

Thus, the pitch size, P, as discussed above may be selected depending on the distance between the detector array 240 and the sample 208 (or vice versa). For example only, for a distance L between the sample 208 and the detector array 240 of approximately 50 micron, the sub-beam pitch p may be equal to or larger than approximately 300 micron. Such a combination may be particularly useful for detecting high energy signal particles, e.g. backscatter signal particles, with an accelerating lens. For example only, for a distance L between the sample 208 and the detector array 240 of approximately 10 micron, the sub-beam pitch p may be equal to or larger than approximately 60 micron. Providing a closer detector array allows use of a smaller sub-beam pitch p. This may be beneficial in using certain configurations in which the sub-beam pitch is beneficially smaller, such as the configuration described in relation to, and shown in, **FIG. 8** below. In a different example arrangement the distance between the sample 208 an the detector array 240 is approximately 50 micron and the sub-beam pitch p is approximately 60 micron. Such a different set up is intended for different operational settings and to detect a different type of signal particle. For example, such a combination may be particularly useful for detecting low energy signal particles, e.g. secondary signal particles, with a decelerating lens. For simultaneous detection of high energy particles (e.g. backscatter signal particles) and low energy particles (e.g. secondary signal particles), the pitch p and distance L may be selected between the values described above so that the high energy particle and low energy particle signals are sufficiently large. It will be noted that there is no relation or limitation for the distance L and the pitch p for the functioning of the detector. However, due to a risk of crosstalk in neighboring detectors it might be preferable to use a larger pitch p for a larger distance L. Although, there may also be other ways to reduce the risk of crosstalk and any appropriate combination of pitch p and distance L may be used.

The detector array 240 (and optionally the objective lens array 241) may be configured to repel secondary signal particles emitted from the sample 208. This is beneficial as it reduces the number of secondary signal particles emitted from the sample 208 which travel back towards the detector array 240. The difference in potential between the detector array 240 and the sample 208 can be selected to repel signal particles emitted from the sample 208 away from the detector array 240. Preferably, the detector array potential may be the same as the potential of the downbeam electrode of the objective lens array. The potential difference between the sample potential and the detector array potential is preferably relatively small so that primary sub-beams are projected through or past the detector array 240 to the sample 208 without being significantly affected. Additionally, a small potential difference will have a negligible effect on the path of a backscatter signal particle (which generally has a greater energy up to the landing energy), meaning that the backscatter signal particles can still be detected whilst reducing or avoiding detection of secondary signal particles. The potential difference between the sample potential and the detector array potential is preferably greater than a secondary signal particle threshold. The secondary signal particle threshold may determine the minimum initial energy of secondary signal particles that can still reach the detector. Preferably, the secondary signal particle threshold is the potential difference equivalent to the likely energy of a secondary signal particle emanating from the sample 208. That is the relatively small potential difference between the sample and detector array potentials is sufficient to repel the secondary signal particles from the detector array. For example, the potential difference between the sample potential and the detector array potential may be approximately 20 V, 50 V, 100 V, 150 V, 200 V, 250 V, or 300V.

The objective lens array 241 may be configured to accelerate the primary charged particles (i.e. the sub-beams) towards the sample 208 along the sub-beam paths 220. Accelerating the sub-beams 211, 212, 213 projected onto the sample 208 is beneficial in that it can be used to generate an array of sub-beams with high landing energy. The potentials of the electrodes of the objective lens array can be selected to provide acceleration through the objective lens array 241. It is noted that an accelerating lens in the arrangement may be particularly useful for detecting ranges (e.g. different energy ranges) of backscatter signal particles. Alternatively, the objective lens array may be configured to decelerate the primary charged particles towards the sample 208 along the sub-beam paths 220. It is noted that a decelerating lens in the arrangement may be particularly useful for detecting both secondary and backscatter signal particles. The figures described below, and particularly **FIGS. 3, 5 and 8,** show the objective lens in the accelerating mode. However, as will be understood from the description above, the objective lens may be used in the decelerating mode instead for any of the embodiments and variations described below. In other words, **FIGS. 3, 5 and 8** could be adapted to decelerate the sub-beams through the objective lenses.

In an arrangement of accelerating objective lens array 241, the low energy particles (e.g. secondary signal particles) generally cannot pass up-beam of the lower part of the accelerating objective lens. It is also increasing difficult for high energy particles (e.g. backscatter signal particles) to pass the accelerating objective lens. This is a key point for both accelerating and decelerating objective lenses. The energy difference between the low energy signal particles (e.g. secondary signal particles) and high energy signal particles (e.g. backscatter signal particles) is proportionately larger down-beam of the objective lens (in both accelerating and decelerating mode) than at any point up-beam of the objective lens. This is beneficial for detection using the detectors described below to distinguish between the different types of signal particles.

The potentials and the values of the potentials defined herein are defined with respect to the source; hence the potential of a charged particle at the surface of the sample may be referred to as a landing energy because the energy of a charged particle correlates to the potential of the charged particle and the potential of the charged particle at the sample is defined with respect to the source. However, as the potentials are relative values, the potentials could be defined relative to other components, such as the sample. In this instance, the difference in potential applied to different components would preferably be as discussed below with respect to the source. The potentials are applied to the relevant components, such as the electrodes and the samples during use, i.e. when the device is being operated.

For example, the device being configured to accelerate the charged particle sub-beams and repel the secondary signal particles as described above may have potentials as shown in the context of **FIG. 5** with the values in Table 1 below. As mentioned above, the objective lens array as shown in **FIG. 5** may comprise an additional electrode, e.g. a middle electrode. Such a middle electrode is optional and need not be included with the electrodes having the other potentials listed in Table 1. The middle electrode of the objective lens array may have the same potential (e.g. VI) as the upper electrode of the objective lens array (i.e. V3).

Exemplary ranges are shown in the left hand column of Table 1 as described above. The middle and right hand columns show more specific example values for each of V1 to V8 within the example ranges. The middle column may be provided for a smaller resolution than the right hand column. If the resolution is larger (as in the right hand column), the current per sub-beam is larger and therefore, the number of sub-beams may be lower. The advantage of using a larger resolution is that the time needed to scan a "continuous area" is shorter (which can be a practical constraint). So the overall throughput may be lower, but the time needed to scan the beam area is shorter (because the beam area is smaller).

Table 1

| | | | |
|---|---|---|---|
| Landing Energy | >10-100 keV | 30 keV | 30 keV |
| V1 (or omitted) | 1-10 keV | 5 keV | 5 keV |
| V2 | >10-100 keV | 29.95 keV | 29.95 keV |
| V3 | 1-10 keV | 5 keV | 5 keV |
| V4 | >10-100 keV | 30 keV | 30 keV |
| V5 | >10-100 keV | 30 keV | 30 keV |

(continued)

| | | | |
|---|---|---|---|
| V6 | 1-30 keV | 4.4 keV | 10 keV |
| V7 | 1-10 keV | 5 keV | 5 keV |
| V8 | >10-100 keV | 29.95 keV | 29.95 keV |

For example, the device being configured to decelerate the charged particle sub-beams and repel the secondary signal particles as described above may have potentials as shown in the context of **FIG. 5** with the values in Table 2 below. The values of the potentials provided for the accelerating lens might be swapped and adjusted to provide a deceleration. For example only, the charged particles may be decelerated from 30kV to 2.5kV in the objective lens. In an example, to obtain landing energies in the range of 1.5 kV to 5 kV, potentials shown in **FIG. 5,** such as V2, V3, V4, V5, V6 and V7, can be set as indicated in Table 2 below. V1 is optionally included if a middle objective lens electrode is included. The potentials and landing energies shown in Table 2 are examples only and other landing energies could be obtained, for example, the landing energy could be lower than 1.5 kV (e.g. approximately 0.3 kV or 0.5 kV) or higher than 5 kV. It will be seen that the beam energy at V1, V3 and V7 is the same. In embodiments the beam energy at these points may be between 10 keV and 50 keV. If a lower potential is selected, the electrode spacings may be reduced, especially in the objective lens, to limit reduction of the electric fields. The potentials in this table are given as values of beam energy in keV, which is equivalent to the electrode potential relative to the cathode of the beam source 201. It will be understood that in designing an charged particle-optical system there is considerable design freedom as to which point in the system is set to a ground potential and the operation of the system is determined by potential differences rather than absolute potentials.

Table 2

| Landing Energy | 1.5 keV | 2.5 keV | 3.5 keV | 5 keV |
|---|---|---|---|---|
| V1 (or omitted) | 29 keV | 30 keV | 31 keV | 30 keV |
| V2 | 1.55 keV | 2.55 keV | 3.55 keV | 5.05 keV |
| V3 | 29 keV | 30 keV | 31 keV | 30 keV |
| V4 | 1.5 keV | 2.5 keV | 3.5 keV | 5 keV |
| V5 | 30 keV | 30 keV | 30 keV | 30 keV |
| V6 | 19.3 keV | 20.1 keV | 20.9 keV | 30 keV |
| V7 | 29 keV | 30 keV | 31 keV | 30 keV |
| V8 | 1.55 keV | 2.55 keV | 3.55 keV | 5.05 keV |

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to the array pitch (i.e. the aperture array pitch described above in relation to the electrodes of the objective lens assembly 241). In an embodiment the outer shape of the detector element 405 is a circle, but this can be made a square or a hexagon to maximize the detection area.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (annular) detector element 405 may provide a good compromise between collection efficiency and parasitic capacitance. A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the tool and can be swapped between operable and non-operable positions without opening the tool.

In some embodiments, one or more aberration correctors are provided that reduce one or more aberrations in the sub-beams. The one or more aberration correctors may be provided in any of the embodiments, e.g. as part of the charged particle-optical device, and/or as part of an optical lens array assembly, and/or as part of an assessment tool. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. up beam or down beam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different sub-beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream (or down-beam). The condenser lenses and correctors may be part of the same structure. For example they may be connected to each other, for example with an electrically isolating element. The aberration correctors may be CMOS based individual programmable deflectors as disclosed in EP2702595A1 or an array of multipole deflectors as disclosed EP2715768A2, of which the descriptions of the sub-beam manipulators in both documents are hereby incorporated by reference.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. The objective lenses and/or control lenses and correctors may be part of the same structure. For example they may be connected to each other, for example with an electrically isolating element. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

In an embodiment, a single detector element 405 surrounds each beam aperture 406. In another embodiment, a plurality of detector elements 405 are provided around each beam aperture 406. Thus, the detector comprises multiple portions, and more specifically, multiple detecting portions. The different portions may be referred to as different zones. Thus the detector may be described to have multiple zones or detection zones. Such a detector may be referred to as a zoned detector. The signal particles captured by the detector elements 405 surrounding one beam aperture 406 may be combined into a single signal or used to generate independent signals. The detector comprising multiple portions may be provided in any of the detector arrays described herein.

The zoned detector may be associated with one of the sub-beams 211, 212, 213. Thus, the multiple portions of one detector may be configured to detect signal particles emitted from the sample 208 in relation to one of the sub-beams 211, 212, 213. The detector comprising multiple portions may be associated with one of the apertures in at least one of the electrodes of the objective lens assembly. More specifically, the detector 405 comprising multiple portions may be arranged around a single aperture 406 as shown in **FIG. 6A** and **FIG. 6B,** which provide examples of such a detector.

The portions of the zoned detector may be separated in a variety of different ways, e.g. radially, annular, or any other appropriate way. Preferably the portions are of similar angular size and/or similar area and/or similar shape, for example as shown in **FIG. 6B.** The separated portions may be provided as a plurality of segments, a plurality of annular portions (e.g. a plurality of concentric annuli or rings), and/or a plurality of sector portions (i.e. radial portions or sectors). The detector elements 405 may be divided radially. For example, the at least one detector 405 may be provided as annular portions comprising 2, 3, 4, or more portions. More specifically, as shown in **FIG. 6A,** the detector 405 may comprise an inner annular portion 405A surrounding aperture 406 and an outer annular portion 405B, radially outwards of the inner annular portion 405A. Alternatively, the detector elements 405 may be divided angularly. For example, the detector may be provided as sector portions comprising 2, 3, 4, or more portions, for example 8, 12 etc.. If the detector is provided as two sectors, each sector portion may be a semi-circle. If the detector is provided as four sectors, each sector portion may be a quadrant. This is shown in **FIG. 6B** in which the 405 is divided into quadrants, i.e. four sector portions is shown in **FIG. 6B,** as described below. Alternatively, the detector may be provided with at least one segment portion. The electrode elements may be separated both radially and angularly or in any other convenient manner.

Each portion may have a separate signal read-out. The detector being separated into portions, e.g. annular portions or sector portions, is beneficial in that it allows more information to be obtained in relation to the signal particles detected. Thus, providing the detector 405 with multiple portions may be beneficial in obtaining additional information relating to the detected signal particles. This can be used to improve the signal to noise ratio of the detected signal particles. However, there is an additional cost in terms of the complexity of the detector.

As shown in **FIG. 6A,** the detector, in which an aperture 406 is defined and configured for the through passage of a charged particle beam, comprises inner detecting portion 405A and outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings. In an example, the detector may be divided into two (or more) concentric rings, for example, as depicted in **FIG. 6A.**

Providing multiple portions concentrically or otherwise may be beneficial because different portions of the detector may be used to detect different signal particles, which may be smaller angle signal particles and/or larger angle signal particles, or secondary signal particles and/or backscatter signal particles. Such a configuration of different signal particles may suit a concentrically zoned detector. The different angled backscatter signal particles may be beneficial in providing different information. For example, for signal particles emitted from a deep hole, small-angle backscatter signal particles are likely to come more from the hole bottom, and large-angle backscatter signal particles are likely to come more from the surface and material around the hole. In an alternative example, small-angle backscatter signal particles are likely to come more from deeper buried features, and large-angle backscatter signal particles are likely to come more from the sample surface or material above buried features.

**FIG. 8** is a schematic diagram of an exemplary charged particle-optical system having the charged particle device as in any of the above described options or aspects. The charged particle optical device having at least the objective lens array 241 as described in any of the aspects or embodiments above may be used in the charged particle-optical system as shown in **FIG. 8.** For conciseness, features of the objective lens array 241 that have already been described above may not be repeated here.

There are some considerations specific to the set up of **FIG. 8.** In the present embodiment, it is preferable to keep the pitch small so as to avoid negatively impacting throughput. However, when the pitch is too small, this can lead to cross-talk. Therefore, the pitch size is a balance of effective detection of a selected signal particle such as a backscatter signal particle and throughput. Thus, the pitch is preferably approximately 300 $\mu$m in such an arrangement for detection of backscatter signal particles , which is 4-5 times larger than it might otherwise be for the embodiment of **FIG. 8** when detecting secondary signal particles. When the distance between the detector and the sample 208 is reduced, the pitch size can also be reduced without negatively affecting the cross-talk. Therefore, providing the detector as close as possible to the sample (i.e. with distance L as small as possible, and preferably less than or equal to approximately 50 $\mu$m, or less than or equal to approximately 40 $\mu$m, or less than or equal to approximately 30 $\mu$m, or less than or equal to approximately 20 $\mu$m, or equal to approximately 10 $\mu$m), is beneficial in allowing the pitch to be as large as possible which improves throughput.

As shown in **FIG. 8,** the charged particle-optical system comprises a source 201. The source 201 provides a beam of charged particles (e.g. electrons). The multi-beam focused on the sample 208 is derived from the beam provided by the source 201. Sub-beams 211, 212, 213 may be derived from the beam, for example, using a beam limiter (which may otherwise be referred to as a beam limiting aperture array) defining an array of beam-limiting apertures. The beam may separate into the sub-beams 211, 212, 213 on meeting the control lens array 250. The sub-beams 211, 212, 213 are substantially parallel on entry to the control lens array 250. (In an arrangement, the control lens array 250 comprises the beam limiter.) The source 201 is desirably a high brightness thermal field emitter with a good compromise between brightness and total emission current. In the example shown, a collimator is provided up-beam of the objective lens array assembly. The collimator may comprise a macro collimator 270. The macro collimator 270 acts on the beam from the source 201 before the beam has been split into a multi-beam. The macro collimator 270 collimates the beam from the source such that beam cross-section is substantially consistent on incidence with the beam limiter. The macro collimator 270 bends respective portions of the beam from which the sub-beams are derived by an amount effective to ensure that a beam axis of each of the sub-beams is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

In another arrangement (not shown), the macro-collimator may be partially or wholly replaced by a collimator element array provided down-beam of the upper beam limiter. Each collimator element collimates a respective sub-beam. The collimator element array may be formed using MEMS manufacturing techniques so as to be spatially compact. The collimator element array may be the first deflecting or focusing charged particle-optical array element in the beam path down-beam of the source 201. The collimator element array may be up beam of the control lens array 250. The collimator element array may be in the same module as the control lens array 250.

In the embodiment of **FIG. 8** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector 265 may be partially or wholly replaced by a scan deflector array. The scan-deflector array 260 comprises a plurality of scan deflectors. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be up beam of an objective lens array 241. The scan deflector array may be down beam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array 260 together, preferably in synchronization.

The invention can be applied to various different tool architectures. For example, the charged particle beam tool 40 may be a single beam tool, or may comprise a plurality of single beam columns or may comprise a plurality of columns of multi-beams (i.e. sub-beams). The columns may comprise the charged particle optical device described in any of the above embodiments or aspects. As a plurality of columns (or a multi-column tool), the devices may be arranged in an array which may number two to one hundred columns or more. The charged particle device may take the form of an embodiment as described with respect to and depicted in **FIG. 3** or as described with respect to and depicted in **FIG. 8,** although preferably having an electrostatic scan deflector array and/or an electrostatic collimator array for example in the objective lens array assembly. The charged particle optical device may be a charged particle optical column. A charged particle column may optionally comprise a source.

As described above, the array of detectors 240 may be provided between the objective lens array 241 and the sample 208, as shown in **FIG. 4** and **FIG. 5.** The array of detectors 240 may be associated with at least one electrode of the objective lens array, preferably, the lower electrode 243. Preferably, the down-beam array of detectors 240 faces the sample 208 in use, i.e. when the sample is present.

Additional or alternative detector arrays may be provided which may be positioned in other places. This is depicted in **FIG. 7.** One, some or all of the detector arrays as shown in **FIG. 7** might be provided. If multiple detector arrays are provided, they may be configured to detect signal particles simultaneously. The detector array 240 positioned between the objective lens array 241 and the sample 208 is shown as a zoned detector as described in relation to **FIGS. 6A and 6B.** However, any appropriate type of detector may be used for this array.

The charged particle-optical device may comprise an array of detectors, referred to herein as an array of mirror detectors 350. The array of mirror detectors 350 is arranged along the primary beam paths 320 (e.g. at a common position along the primary beam path). The array of mirror detectors 350 is configured to face up-beam of the primary beam paths 320. In other words, the array of mirror detectors 350 is configured to face along the primary beam path 320 towards a source of the primary beam (described above as source 201). The array of mirror detectors 350 is configured to face away from the sample 208. The array of mirror detectors 350 may otherwise be referred to as an upwards array of detectors. Preferably, the array of mirror detectors 350 is associated with the lower electrode 243, and preferably an up-beam surface of the electrode. This may be beneficial as the signal particles may be more likely to be detected if the array of mirror detectors 350 are provided relatively close to the sample 208, e.g. just above or on the lower electrode 343. When the array of mirror detectors 350 is positioned within the objective lens array 241 (i.e. between electrodes of the objective lens array 241) it may be referred to as an in-lens detector. In an arrangement of an objective lens array assembly with multiple lensing electrodes, other electrodes may feature a mirror electrode, so long as another electrode is located up beam of the mirror electrode to mirror the signal particles towards the mirror electrode.

The charged particle-optical device may comprise at least one up-beam array of detectors facing towards the sample, i.e. in the direction of the sample 208. In other words, the up-beam array of detectors may be facing in a direction along the primary beam path 320 towards the sample 208. The charged particle-optical device may comprise upper array of detectors 370. The upper array of detectors 370 may be associated with the down-beam surface of the upper electrode 242 of the objective lens array 241. More generally, the upper array of detectors 370 could be associated with a down-beam surface of any appropriate electrode if more electrodes are provided in the objective lens array. The upper array of detectors 370 may be positioned between the upper electrode 342 and the lower electrode 343, or between any other electrodes above the lowest electrode of the objective lens array. As described above, the upper array of detectors 370 is provided up-beam (in relation to the primary sub-beams 211 and 212) of at least one electrode, which is the lower electrode 243 in relation to **FIG. 7.** Additionally or alternatively, the charged particle-optical device may comprise an above-lens array of detectors 380. In other words, the up-beam array of detectors may be above the objective lens array 241. The above-lens array of detectors 380 may be up-beam of all the electrodes forming the objective lens array 241. The above-lens array of detectors 380 may be spaced apart from the electrode 242 so that the above-lens detector array 380 is a plate or substrate with its own mechanical support separate from the objective lens array. A Wien filter array may additionally be used to direct the signal particles towards detectors located between the sub-beams (e.g. when in the above-lens detector array), or the signal particles may be directed to a detector array positioned outside of the primary sub-beam paths.

Any of the detector arrays may be associated with (e.g. in, on, positioned adjacent to, connected to, or integrated with) at least one electrode of the objective lens array 241 (e.g. either the upper electrode 242 or the lower electrode 243). For example, the array of detectors may be in or on at least one electrode of the objective lens array 241. For example, the array of detectors may be positioned adjacent to one of the electrodes. In other words, the array of detectors may be positioned in close proximity and next to one of the electrodes. For example, the array of detectors may be connected (e.g. mechanically connected) to one of the electrodes. In other words, the array of detectors may be attached to one of the electrodes, e.g. by adhesive or welding or some other attachment method. For example, the array of detectors may be integrated with the one of the electrodes. In other words, the array of mirror detectors may be formed as part of one of the electrodes.

Combinations of the detector arrays may be provided. For example, the down-beam array of detectors 240 and/or the array of mirror detectors 350 and/or the upper array of detectors 370 and/or the above-lens array of detectors 380 may be provided. The device may comprise an additional array of detectors which may be provided with any combination of the down-beam array of detectors 240 and/or the array of mirror detectors 350 and/or the upper array of detectors 370 and/or the above-lens array of detectors 380. As will be clear from the above described combinations of arrays, there could be any appropriate number of detector arrays. For example, there could be two, or three, or four, or five, or more arrays of detectors which are positioned at any appropriate place, for example, as described above in relation to the up-beam array of detectors and/or the down-beam array of detectors. Whichever detector arrays are provided may be used simultaneously. A potential of any of the detector arrays (e.g. the array of mirror detectors 350 and/or the upper array of detectors 370 and/or the above-lens array of detectors 380 and/or the down-beam array of detectors 360 and/or any additional array of detectors) relative to a potential of the sample 208 may be selected to control detection of the signal particles at least that detector array. The array of sub-beams (otherwise referred to as an array of primary beams) may correspond with any/all detector arrays provided. Thus, the array of sub-beams may correspond with the array of mirror detectors 240, and/or the down-beam array of detectors 360, and/or the upper array of detectors 370 and/or above-lens array of detectors 380. Thus, any/all of the detector arrays may be aligned with the sub-beams.

**FIG. 9** is a schematic diagram of an exemplary single beam charged particle beam tool 40 according to an embodiment. As shown in **FIG. 9,** in an embodiment the charged particle beam tool 40 comprises a sample holder 207 supported by a motorized stage 209 to hold a sample 208 to be inspected. The charged particle beam tool 40comprises an charged particle source 201. The charged particle beam tool 40 further comprises a gun aperture 122, a beam limit aperture 125 (or beam limiter), a condenser lens 126, a column aperture 135, an objective lens assembly 132, and an charged particle detector 144 (which may otherwise be referred to as an electron detector). The objective lens assembly 132, in some embodiments, may be a modified swing objective retarding immersion lens (SORIL), which includes a pole piece 132a, a control electrode 132b, a deflector 132c, and an exciting coil 132d. The control electrode 132b has an aperture formed in it for the passage of the charged particle beam. The control electrode 132b forms the surface facing the sample 208. Although the charged particle beam tool 40 shown in **FIG. 9** is a single beam system, in an embodiment a multi-beam system is provided. Such a multi-beam system may have the same features as shown in **FIG. 9,** such as the objective lens assembly 132. Such a multi-beam system may have in addition beam limiter array, for example down-beam of the condenser lens, for generating the sub-beams. Associated with the beam limiter array, such as down beam of the beam limiter array, may be a number of charged particle array elements such a deflector array and a lens array for optimizing and adjusting the sub-beams and reducing aberrations of the sub-beams. Such a multi-beam system may have a secondary column for detecting signal charged particles. A Wien filter may be up-beam of the objective lens assembly to direct the signal particles towards a detector in the secondary column.

In an imaging process, a charged particle beam emanating from the source 201 may pass through the gun aperture 122, the beam limit aperture 125, the condenser lens 126, and be focused into a probe spot by the modified SORIL lens and then impinge onto the surface of sample 208. The probe spot may be scanned across the surface of the sample 208 by the deflector 132c or other deflectors in the SORIL lens. Signal particles emanated from the sample surface may be collected by the charged particle detector 144 to form an image of an area of interest on the sample 208.

The condenser and illumination optics of the charged particle beam tool 40may comprise or be supplemented by electromagnetic quadrupole charged particle lenses. For example, as shown in **FIG. 9** the charged particle beam tool 40may comprise a first quadrupole lens 148 and a second quadrupole lens 158. In an embodiment, the quadrupole lenses are used for controlling the charged particle beam. For example, first quadrupole lens 148 can be controlled to adjust the beam current and second quadrupole lens 158 can be controlled to adjust the beam spot size and beam shape.

As described above, a zoned detector may have a plurality of detector portions (e.g. sensor elements) as part of a detector element 405 as described above in relation to **FIGS. 6A and 6B.** The plurality of detector portions for each detector element (or sensor unit) is provided around an aperture. The plurality of detector portions may, together, have a circular perimeter and/or a diameter. The plurality of detector portions may, together, have an area extending between the aperture and the perimeter of the plurality of detector portions. The pluralities of detector elements may be arranged in rectangular array or a hexagonal array. The signal generated from signal particles captured by detector portions surrounding one aperture may be combined into a single signal or used to generate independent signals. The surfaces of the detector elements, optionally their detector portions, may substantially fill the surface of the substrate supporting the detector elements.

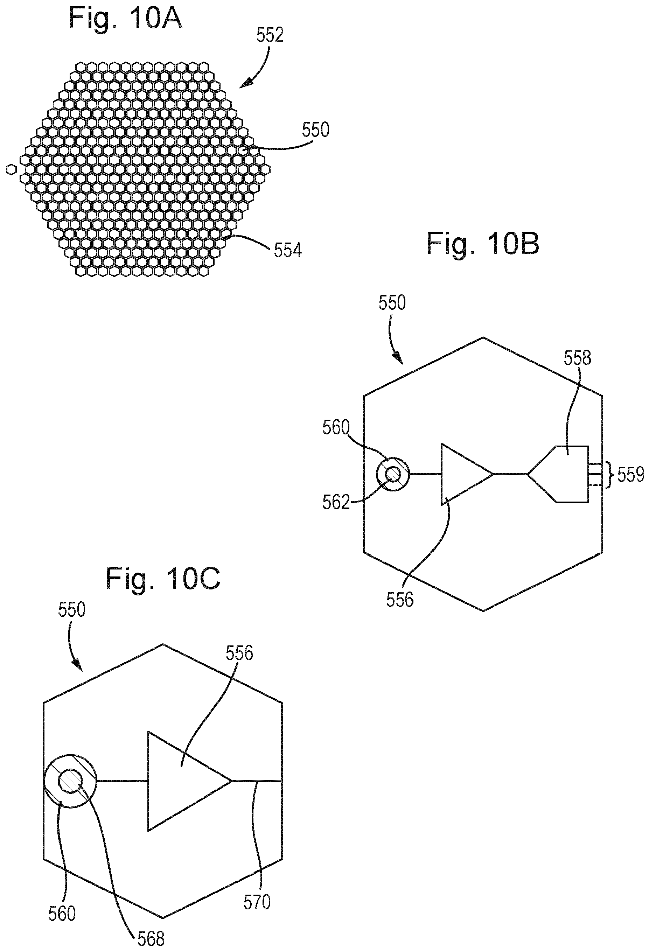

As shown in **FIG. 10A** a surface of a detector array or detector module facing, even proximate in use to, a sample features an array of detector elements (or an array of detectors). Each detector element is associated with an aperture. Each detector element is associated with an assigned surface area of the substrate of the detector module . As the substrate is layered, for example in having a CMOS structure, each layer within the substrate is positioned with respect to the respective detector elements, preferably proximately. Commercially available CMOS structures have a usual range of layers, for example three to ten, usually about five. (For example, two functional layers may be provided for ease of description. These two layers of wiring layer and logic layer may represent as many layers as required and each layer is not restricted to wiring or logic, respectively.) The number of layers is limited by commercial availability and any number of layers is feasible. However, in view of practicality, the substrate has a limited number of layers, in order for an efficient design the available space is limited.

Ideally a circuit layer of the substrate, which can be the wiring layer and/or logic layer, has a portion assigned for each detector element (or detector). The assigned portions of the different layers may be referred to as a cell 550. The arrangement of portions in the substrate for the full multi-beam arrangement may be referred to as a cell array 552. The cells 550 may be same shape as the surface area assigned for each detector element, such as hexagonal, or any reasonable shape that may tesselate and may all be similar in shape and/or area, such as a rectangular shape. Having a rectangular or rectilinear shape can more readily be used by placing and routing design. Such design is commonly implemented by software that is suited to define chips with an rectangular type architecture with orthogonal directions, than architecture requiring acute or obtuse angles such as in a hexagonal architecture. In **FIG. 10A** the cells 550 are depicted as being hexagonal and the cell array 552 is depicted as a hexagon comprising individual cells. However, ideally each similarly located with respect to detector elements. Wiring routes 554 may connect to each cell 550. The wiring routes 554 may be routed between other cells of the cell array 552. Note: reference to wiring routes to be between cells of the array, it is intended that at least the wiring routes avoid the beam apertures of the array of apertures, e.g. defined through the cell array. In an arrangement circuit architecture, the cell size in at least the circuit layer may be reduced to accommodate the wiring routes, so that the wiring routes are routed between cells. Additionally or alternatively the wiring routes pass through the cells of the cell array, preferably towards the perimeter of the cells for example to reduce the interference of the wiring routes with other circuitry in the cells. Therefore reference to a wiring route between the cells encompasses: a wiring route between the circuitry of cells, a wiring route within cells, preferably towards the periphery of the cells and at least around the beam apertures through the cells and any intermediate variation. In all these arrangements, for example in a CMOS architecture, the wiring routes may be in the same die as the other circuitry which may define circuitry in the same cell as a portion of the wiring route, or circuitry in a cell around which the wiring route is routed. Thus, the cells and wiring routes may parts of a monolithic structure. The wiring routes 554 may signally connect the cells. Thus the wiring routes signally connect the cells 550 to a controller or data processor external to the cell array or even the substrate or detector module. The circuit layer may comprise a datapath layer for the transmission of sensor signals from a cell outward of the cell array.

The controller or data processor may before circuitry within the substrate or detector module, preferably external to the cell array for example as control and I/O circuitry (not shown). The control and I/O circuitry may be in the same die as the cell array; the control and I/O circuitry may be monolithically integrated with the cell array, for example in the same CMOS chip. The control and to I/O circuitry enables an efficient connection between the data from all the cells of the cell array 552. Consider for example an arrangement of 2791 cells each having an 8 bit digital output. Such an arrangement would have 22328 signals (i.e. 8 bit output *2791cells) to the electronics located outside the CMOS chip. The standard way of doing this is to use a SERDES circuitry (serializer / deserializer). Such circuitry would transform a large number of low data rate signals into a few number of high data rate signals by means of time division multiplexing. It is therefore beneficial to have control and I/O circuitry monolithically with the cell array, or at least in the detector module, than external to the detector module.

In embodiments the control and I/O circuitry may feature general supporting functions, such as circuitry to communicate with the electronics outside the CMOS chip to enable loading certain settings, for example for control of amplification and offset such as subtraction as described herein.

The circuit layer of a cell 550 is connected to a detector element of the respective cell. The circuit layer comprises circuitry having amplification and/ digitation functions, e.g. it may comprise a amplification circuit. A cell 550 may comprise a trans impedance amplifier (TIA) 556 and an analogue to digital converter (ADC) 558 as depicted in **FIG. 10B.** This figure schematically depicts a cell 550 with an associated detector element such as capture electrode and a feedback resistor 562 connected to the transimpedance amplifier 556 and the analogue to digital converter 558. The digital signal lines 559 from the analogue to digital converter 558 leave the cell 550. Note that the detector element is represented as a detector element 560 and feedback resistor is shown associated with the detector area as a disc 562 rather than associated with the transimpedance amplifier 556. This schematic representation is to represent each of the detector element and the feedback resistor as an area to indicate their relative size, the reason for which will become apparent when referring to **FIG 10C.**

The transimpedance amplifier may comprise a feedback resistor Rf 562. The magnitude of the feedback resistor Rf should be optimized. The larger the value of this feedback resistor, the lower the input referred current noise. Thus the better signal-to noise ratio at the output of the transimpedance amplifier. However, the larger the resistance, Rf, the lower the bandwidth. A finite bandwidth results in a finite rise and fall time of the signal, resulting in additional image blur. An optimized Rf results in a good balance between noise level and additional image blur.

To implement the design the circuitry i.e. the amplification circuitry associated with each detector element should be within the layers of the associated cell 550 and fit in the limited area available of the portions of each associated layer. In the case of a sub-beam pitch of 70 micron, the available area per layer in the cell is typically only 4000 square micron. Depending on the sensed secondary and/or backscatter signal particles, for example as current to be measured by the detector element, the optimum value for the feedback resistor Rf can be as high as 30 to 300MOhm. If such a resistor would be implemented as a poly resistor in a standard CMOS process the size of such resistor would be much larger than the area that is available in the CMOS layers of the cell 550. For example, a resistor of 300MOhm would consume around 500000 micron^2. This is about 130 times larger than the entire available area.

Typically, for example in CMOS architecture, such a large resistor would be made in a single layer for example of polysilicon. Usually there is a single layer of polysilicon. In some circumstances a layer could be provided having material capable of providing high resistor values, although with such a high aspect ratio (e.g. extreme length relative to width of the resistive structure in the layer) the reliability of the resistor remains. Even if the cell were to have multiple layers used for such a resistor, many more layers would have to be present that is readily available for example using CMOS technology. Additionally or alternatively, the meandering path through different layers would not mitigate the high aspect ratio and risk of variation in the resistance value would only be contributed by the interconnections between different layers. Such interconnects influence the variability of the resistance value of a resistor as a corner, as later described herein.

Note that such dimensions are calculated assuming a 180 nm node architecture and processing. If alternatively a smaller processing node is used, it is unlikely that a factor of thousand in reducing the dimensions of the resistor structure could be gained. Further, using 180 node architecture is preferred to a smaller node for processing reasons. For instance interconnects in a 180 nm node are simpler to process. Post processing of a detector chip for example in etching the beam apertures 504 uses aluminum interconnects. Such post processing at a sub-180nm node typically uses a process with Copper interconnects. Processing at 180 nm is therefore simpler than at sub-180 nm.

Further if such a resistor were made, in whichever node, the reliability of the resistor specifications as well as the space available for the resistor may be challenging.

In a layered structure for chip architecture, such as CMOS, the components and features are defined as structures in a layer. The specification of a component is dependent on the material of the layer and the physical properties of the layer, the dimensions of the layer, specifically its thickness and the dimensions of the structure formed in the layer. A resistor may take the form of a long narrow path, route or wire. In view of space constraints, the path may be non-linear, having corners along its path. For such a long component, the width of the path in the layer may vary such as through manufacturing tolerances. A corner may provide greater variance than a linear section of the path, limiting the accuracy with which the resistor can be made in order to have a specified resistance. With many corners and a long length, a resistor having such topology may made with poor reliability so that the resistances for equivalent resistors in different cells of the cell array may have a large range.

Such a resistive structure has a large surface area. Additionally or alternatively, a resistor with such a large surface area would additionally have a capacitance which is undesirable; such a capacitance is referred to as a parasitic capacitance. Parasitic capacitances may undesirably contribute to noise and blur, influencing the balance between noise, blur and bandwidth optimization which is elsewhere herein described

The material properties of the layer can be modified chemically; however such modifications are unlikely to achieve the improvement of several orders of magnitude in size to fit into available space in the cell. Such modifications are unlikely to change the topography of the feedback resistor sufficiently so that has the required specification and can be made with the desired reliable accuracy.

Such requirements in reliability and size would enable the resistor to achieve its desired performance in terms of bandwidth, signal to noise ratio, and stability. Unfortunately these requirements cannot be met.

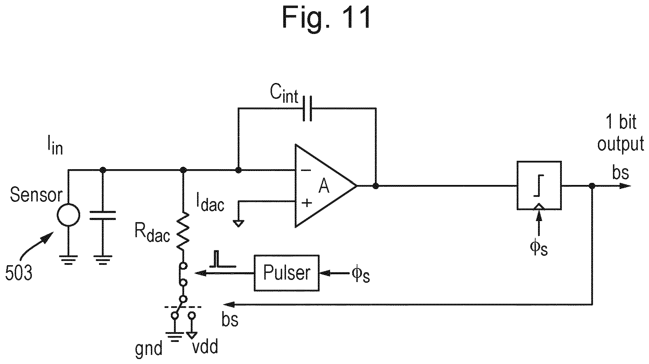

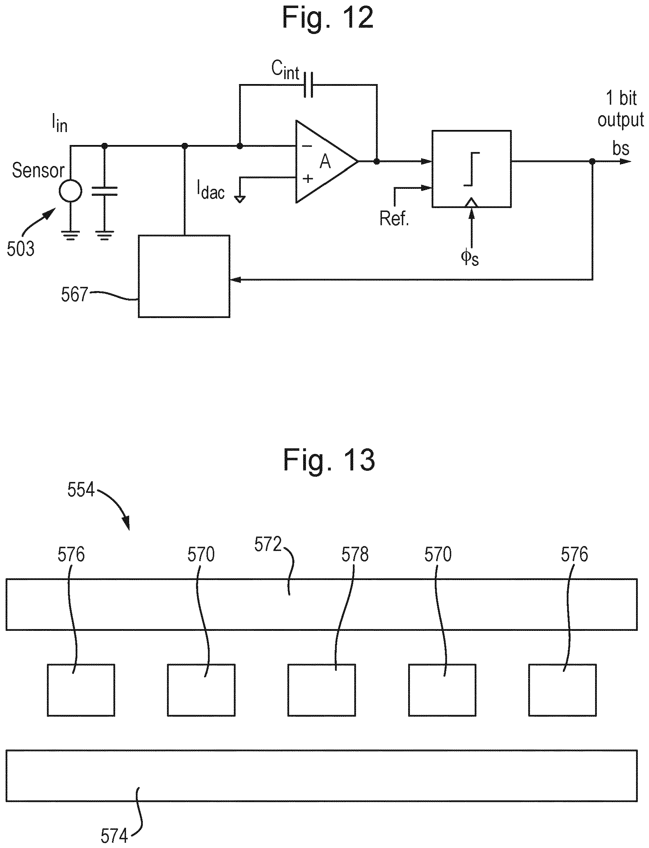

Alternative amplification circuitry is proposed which does not require such a large feedback resistor. Examples include a trans impedance amplifier with a pseudo resistor as a feedback element and a direct analogue to digital converter, obviating the need for a transimpedance amplifier. Two examples of a direct analogue to digital converter are: using a low duty cycled switched resistor, **FIG 11,** and using a reference capacitor, **FIG. 12.** An optional arrangement is to remove the analogue to digital converter 558 from the cells 550 so that a circuit wire 570 connects the trans impedance amplifier 556 in the cell 550 with the analogue to digital converter external to the cell array 552, **FIG 10C.** The arrangement depicted in **FIG. 10C** may be applied to an amplifier circuit, e.g. as depicted in **FIGS. 11 and 12.** Each option is now mentioned in turn. The example amplifier circuits described are just some of the suitable types of amplification circuitry that can be used. Other amplifier circuits may exist which achieve similar benefits to those described herein and which use similar circuit architecture for each cell as herein described.

An alternative amplification circuit is a direct analogue to digital converter for example using a switched resistor or capacitor, as depicted in **FIGS. 11 and 12** that are connected directly to the output of a detector elements 503. A suitable type of direct analogue to digital converter is a charge-balancing direct current-to-digital converter. Using a direct analogue to digital to converter avoids using a trans impedance amplifier and having the feedback resistor Rf or an exotic alternative. Removing the transimpedance amplifier removes the most power consuming component in the amplification circuit and the main source of input noise. Delta/sigma modulators provide the best realization of charge-balancing direct current-to-digital converter. The two possible solutions are depicted in **FIGS. 11 and 12** are: using as a reference a low duty cycle switched resistor; and using as a reference a switched capacitor. These circuits are exemplary and other suitable circuits may exist

A suitable direct current-to-digital converter with low duty cycle switched resistor, is depicted in simplified form **FIG 11.** The circuit has an integrator A to which is input the output from the detector elements 503 and the reference resistor $R_{dac}$. A capacitor $C_{int}$ is in a feedback loop of the integrator A. The signal output from integrator A is processed by a comparator to for the final step of converting the analogue signal to a digital signal. A bit stream bs provides a feedback from the output of the comparator to a control switch for the reference current $I_{dac}$ using a charge balance loop. The design of control switch helps to ensure a long term stable balance between the sensor current $I_{in}$ and the reference current $I_{dac}$. This helps ensure that the integrator will not clip its output signal and output bit stream, bs, is a digitised version of the sensor current $I_{in}$

In using such direct current-to-digital converter with low duty cycle switched resistor a the size of a reference resistor $R_{dac}$ is reduced, for example in realizing it a CMOS circuit. This is achieved by connecting the reference resistor $R_{dac}$ to the input of the integrator A for a very small portion t of the clock period $T_{clock}$. This results in a small duty cycle: $t/T_{clock}$, e.g. 1:1000. This short connection time is sufficient to deliver the charge in reference current $I_{dac}$ required to balance the charge delivered in the current $I_{in}$ from the detector element, i.e. the sensor current. Providing a reference current in this way to balance the sensor current helps to ensure that the reference noise is small. Yet, using such a low duty cycle enables the same effect that would otherwise be achieved by a large resistor such as the feedback resistor Rf of a standard trans impedance amplifier. So this solution applies a smaller sized resistor than would otherwise be used and using the duty cycle to boost its effective size yet minimizing the actual size of the resistor and the effective are of the circuit layer in a cell required by this type of amplification circuit.

A suitable direct current-to-digital converter with a reference capacitor is depicted in simplified form in **FIG. 12.** The circuit has exactly the same features as the current-to-digital converter with low duty cycle switched resistor as depicted in **FIG. 11,** unless otherwise specified. A capacitive digital-to-analog converter 567 arranged in a switched configuration supplies the reference current. Such a switched capacitor digital-to-analog converter contains at least one capacitor and may contains a parallel capacitor network. Individual capacitors are connected or disconnected with switches based on the input. As a capacitor based circuit, the capacitive digital-to-analog converter 567 may be represented as reference capacitor $C_{dac}$ Instead of a reference resistor $R_{dac}$ a reference capacitor Cdac is used. Because a capacitor is used, selection of an appropriately sized capacitor will generate a suitable reference current $I_{dac}$, so that the a pulsar powered by a or clock signal $f_s$ to the reference circuit is not required. In restricting the use of the clock to the integrator, the effect of clock jitter is minimized. The effect of the reference current $I_{dac}$ on the sensor current $I_{in}$ is to quantize the signal of the sensor current. This is in effect direct digital conversion.

As depicted in **FIG. 10C,** a cell 550 comprises a transimpedance amplifier 556 connected to a detector element 560. Associated with this amplification circuitry is an effective feedback resistor 568. The output of the transimpedance amplifier is connected to an analogue to digital converter 558 (not shown) which is remote from the cell. A circuit wire 570 connects the trans impedance amplifier and the analogue to digital converter. The circuit wire 570 transmits an analogue signal. Considering that cell array 552 is densely packed, the analogue to digital to converter is external to the cell array for example one the same die as the cell array 552 and/or monolithically integrated with the cell array 552. In an embodiment the analogue to digital converter 558 is in the substrate of the detector module. Alternatively the analogue to digital converter is remote from the substrate, for example it is part of a processor external to the substrate.

The differences in components between the cells depicted in **FIGS. 10B and 10C** are that the cell of **FIG. 10C** only includes a trans impedance amplifier and not an analogue to digital convert and the circuit wire 270 transmits an analogue signal rather than the digital signal transmitted by the analogue to digital converter. By removing the analogue to digital converter from the cell 550, there is more space available in the circuit layer of the cell 550 for a feedback resistor element. This relative difference can be noted by the relative size of the feedback resistor areas 562 in **FIGS. 10B and 10C;** (but note, the relative dimensions do not necessarily apply to other features of these two figures). There is yet more space in the circuit layer of the cell 550 if the amplifier circuitry uses an alternative trans impedance amplifier circuit, for example if a trans impedance amplifier with a pseudo resistor is used as a feedback element.

Although it may be easier to fit the trans impedance amplifier 556 with a pseudo resistor feedback element and analogue to digital converter in the circuit layers of the cell, in an arrangement it is more practical for space constraints for the analogue to digital converter 558 to be external to the cell array 552. This is despite the use of a pseudo resistor in the feedback element of the trans impedance amplifier providing a gain of one to two orders of magnitude in area. One consideration to decide whether or not the analogue to digital converter 558 is external to the cell array 552 is the sub-beam pitch of the multi-beam. For example with a sub-beam pitch of 70 micron, typically only 4000 square micron is available per layer of a cell for the circuitry including the amplification circuitry.

Under such space constraints, a trans impedance amplifier is located in the cell of each beam. The analogue to digital converter is located outside the array of sub-beams, i.e. outside the cell array. In an embodiment, the analogue to digital converter is present on the same die as the cell array, for example monolithically with the cell array. Such an analogue to digital converter may be located with the control and I/O circuitry which may be on the detector module or even monolithic with the cell array 552. Locating the analogue to digital converter external to the cell array may provide an area gain of about a factor of two.

The circuit wire 570 connects the trans impedance amplifier in a cell 550 with the associated analogue to digital converter 558. The circuit wire 570 transmits an analogue signal. Unlike a digital signal, a data path transmitting an analogue signal is susceptible to interference. Signal interference can be from cross-talk with other circuit wires and from external fields such as generated by the sub-beams of the multi-beam and fields from nearby charged particle optical components such as the objective lens array 241.

The circuit wire 570 is routed through the a wiring route 554 as depicted in **FIG. 10A.** The wiring route 554 is routed between cells so that the area of a cell and its layers is used for the amplification circuitry present on a cell. The wiring route 554 therefore only uses a portion of the circuit layers in which the wiring route is present, namely between adjoining cells 550 (e.g.. at least around the beam apertures 504, 406 of the adjoining cells 550; through the adjoining cells 550 such as towards the periphery of the cells or between the circuitry in a layer assigned to the adjoining cells 550, or any arrangement between the stated arrangements). This routing avoids architectural interference of the amplification circuitry and the architecture of the wiring routes 554. Circuit wires are routed along the wiring routes in the cell array in an outward direction, for example in a radially outward direction. With greater proximity to a perimeter of the cell array 552, there may be more circuit wires 570 than in a portion of the wiring route 554 remote from the perimeter. The wiring route may have a plurality of circuit wires 570, which as described, is between cells of the array. Therefore a portion of the wiring route 554 may have more than one circuit wire 570. However, having circuit wires located close to each other risks crosstalk between the circuit wires and interference of the analogue signals transmitted by the circuit wires 570.

The risk of crosstalk and signal interference may be at least reduced or even prevented by having the circuit wires 570 shielded from each other within the wiring route. **FIG. 13** depicts cross-section of an exemplary arrangement of wiring route 554. Within the wiring route 554 are one or more circuit wires 470, shown extending in same direction as the wiring route 554 and a shielding arrangement. The circuit wires are shown in the same layer. Above the circuit wires 570 is an upper shielding layer 572; beneath the circuit wires 570 is a lower shielding layer 574. The upper and lower shielding layers of the shielding arrangement shield the circuit wires 570 from fields external to the wiring route 554 above and beneath the wiring route 554. The shielding arrangement has shielding elements in the same layer as the circuit wires 570. The shielding elements may be outer elements 576 at the outer edges of the layer comprising the circuit wires 570. The outer elements 576 shield the circuit wires 570 from fields external to the wiring route 554. The shielding elements may include intermediate shielding elements 578 that are present in the layer between adjoining circuit wires. The intermediate shielding elements 578 may therefore at least suppress if not prevent cross-talk between the circuit wires 570. In operation, a common potential is applied to the shielding layers 572, 574 and shielding elements 576, 578. The potential may be a reference potential for example a ground potential.

Although **FIG. 13** depicts a three layer arrangement, as many layers may be used in the wiring route 570 as may be desired. For example, there may be two layers of circuit wires, requiring three shielding layers which include an upper shielding layer 572, a lower shielding layer 574 and an intermediate shielding layer. The intermediate shielding layer may additionally reduce if not prevent crosstalk between the circuit wires in the different layers of the wiring route 570. Thus, there are five layers in total. Every additional layer of circuit wires requires an additional intermediate shielding layer. Whereas increasing the number of layers in the wiring route 554 reduces the proportion of a layer that wire routing requires, such a variation in design requires additional layers. In view of the limited number of layers, there is an optimum number of layers at which the width of the wiring route is reduced without exceeding the number of layers required elsewhere in the substrate of the detector module, which can be limited to five layers.

A further consideration of the design of wiring route is the number of circuit wires that may need to be present in an exemplary design of detector module, for example consider the arrangement of **FIG. 13** with all circuit wires 570 in a layer.

For example, an array of sub-beams is arranged an hexagonal array with thirty (30) rings. The detector module therefore has a cell array of corresponding design. The number of cells is around 3000, for example 2791. Assuming such a cell array has a pitch of seventy (70) micron, the innermost cell is a ring of zeroth order, Ring #0, and has a single cell; the innermost ring, Ring #1, is around the central cell; and the outermost ring, Ring N, defines the perimeter of the cell array and consists of 6N cells. For a cell array of thirty rings, the total number of cells equals:

$$N_{cell} := 1 + \sum_{n=1}^{30} (6n) = 2.791 \text{ x } 10^3$$

The outermost ring has the highest number of signals that need to be routed through the ring. Considering the wiring route is routed between cells of the each cell, these signals are routed through the outermost ring between the cells of the outermost ring. Because the outermost ring consists of 180 cells (e.g. thirtieth ring multiplied by six, i.e. 30*6= 6N), the number of signals transported through the outermost ring, e.g. between the cells of the outermost ring, is:

$$1 + \sum_{n=1}^{29} (6n) = 2.611 \text{ x } 10^3$$

The maximum number of signals to be routed through the outer ring between adjacent cells is the total number of signals (2611) divided by the number of cells in the outermost ring (180). This is fifteen 15 (rounded up to the nearest whole number). So that the signals are well shielded, for example to limit crosstalk and the influence of external fields, the wiring route has a shielding arrangement. In a single layer of wire circuits, the layer may have outer elements 576 at the edges of the wiring route and intermediate shielding elements 578 between adjacent circuit wires 570 . With a wiring route of fifteen (15) circuit wires 570, there are sixteen shielding elements, including fourteen (14) intermediate shielding elements and two outer shielding elements 576. Therefore between adjacent cells 550 of the outer ring of the example, a wiring route having all circuit wires in the same layer would have thirty-one (31) elements of alternate shielding elements and circuit wires.

For cell array 552 for a beam array with a pitch of 70 microns, there is enough space, or area, available in the circuit layer, for such a wiring route 554. In a structure created using a process at the 180nm node, the minimum half pitch of a metal layer is typically around 280nm. In this context a half pitch is a line and a pitch is the line with an associated gap with an adjoining gap. The associated gap is typically the same width the line. The wiring route for thirty-one elements requires thirty-one pitches. However, the associated gap of one of the elements, that corresponds to the outer elements 576, is not part of the wiring route 554, but would separate the wiring route from adjoining circuitry. Therefore, for thirty one elements, sixty-one (61) half pitches are required, which corresponds to a width of the circuit wiring 554 of 17.1 micrometers.

In a different arrangement, the beam array may be hexagonal having 108 rings and around 35000 cells, and may be considered to be a monolithic beam array. The outermost ring has around 650 cells. Around 34350 signals are required to be routed through the outermost ring. So around 54 signals need to be routed through adjoining cells in the outermost ring. A wiring route 554 having 54 circuit wires 570 has 55 shielding elements. Applying a similar calculation as for the previous example in applying this architecture to a half pitch of 280nm, the width of the circuit wire would be under 61 micrometers. This size would fit between the cells 550 of the outermost ring. In an alternative arrangement the beam arrangement is apportioned in to two or more strips with one or more intermediate strip for routing a support structure, cooling features such as conduits, data transmission lines and the like. Such a beam array may be referred to as a stripped beam array. The wiring routes may therefore be routed through the one or more intermediate strips. This enables a larger beam array, thus cell array yet maintaining a reasonably sized wiring route. If a stripped beam array were to have the same number of sub-beams as a monolithic beam array, the wiring routes would have fewer circuit wires 570 than the monolithic cell array i.e. fewer than 54. Indeed a stripped beam array may achieve a larger number of sub-beams than a monolithic beam array because the size of the beam array, as limited by the maximum number of circuit wires that may be in the wiring route, would be larger

The optimization of the noise performance for example in terms of bandwidth and noise optimization and balance between the blur and the noise can be enabled by making sure an amplification factor of the trans impedance amplifier is programmable. In a such an arrangement, the amplifier circuit of the cell, at least the trans impedance amplifier, is programmable. Such a programmable amplification circuit may comprise a variable amplifier and/or a variable analogue to digital converter for example, in terms of its sensitivity.. The variable amplifier has a variable amplification range dependent on a detected beam current detected by a detector element503. For example, when the detected beam current is low, or for a sample with a lower than typical secondary emission coefficient, the variable amplifier can be adjusted to provide a larger amplification than normally used. When a larger beam current than normal is detected by a detector element 503, or for a sample with a larger than typical secondary emission coefficient, the variable amplifier can be tuned to provide a smaller amplification.

This functionality is beneficial with a trans impedance amplifier with a feedback element having pseudo resistor. A pseudo resistor has different effective resistances on application of different applied voltages; unlike an ideal resistor which has a single resistance at all applied potential differences. In providing different resistance, the trans impedance amplifier associated with the pseudo resistor operates as a variable amplification. In providing an amplifier with variable functionality, an optimized balance between noise levels and image blur (referred to herein above as 'additional blur') may be achieved. Beneficially, the programmable amplification circuit may match the output of the trans impedance amplifier with the input of the analogue to digital converter. This may be as a programmable offset that is subtracted between the output of the trans impedance amplifier, and the input of the analogue to digital converter. The programmable offset may help reduce the required number of bits that need to be transmitted from the amplification circuit of a cell. The programmable offset may be implemented in the programmable amplifier. These measures help to ensure that the dynamic range of the trans impedance amplifier and the analogue to digital converter, and thus preferably the amplification circuit, are optimally used for different use cases. Such different use cases may include: the material properties of a sample under inspection, different assessment tool configurations for example using different beam currents. The range of applications may be enabled by the provision of a variable amplifier and a variable off set or threshold (e.g. subtraction by a programmable offset) desirable enables tuning of amplification, threshold and bandwidth As mentioned elsewhere herein, the circuitry associated with variable amplification and subtraction may be comprised in the control and I/O circuitry.

It is beneficial to detect different types of signal particles in order to obtain more varied information relating to the sample. For example, in order to measure an overlay target, one might use secondary signal particles to obtain data relating to a top grating (possibly present in resist) and use backscatter signal particles to obtain data relating to a buried grating.

In some systems, detectors may be provided to be used in different modes, e.g. switching between secondary signal particle detection and backscatter signal particle detection. In order to switch from secondary signal particle detection to backscatter signal particle detection, the electrostatic field between sample and detector is reversed and/or the landing energy is changed. Different sample charging conditions after changing landing energy and/or sample field can cause an overlay measurement error, because these might change the primary beam position. There is a risk the system drifts (sample position and/or beam position) while switching, resulting in an overlay measurement error. Thus, improvements can be made to a system in which detection modes are switched between backscatter detection and secondary detection. European Application 20216927.2 discloses such a system and at least the devices and methods relating to switching between different modes are hereby incorporated by reference.

In alternative systems, a detector is provided with a double ring detector pad. The use of a double ring charged based bottom detector may lead to a considerable amount of cross signals in the rings, i.e. detection of secondary signal particles in the outer ring proposed to detect backscatter signal particles, and detection of backscatter signal particles in the inner ring proposed to detect secondary signal particles. European Application 21174518.7 discloses such a system and the devices and methods related to the double ring detector pad are hereby incorporated by reference.

In an implementation of the present invention, detection using two types of detector element is sought to be improved, e.g. by making use of more of, if not the complete, available detection efficiency. The separation of secondary signal particles and backscatter signal particles can be achieved by using the large energy difference between secondary signal particles and backscatter signal particles as described above. In the present invention both the secondary signal particles and the backscatter signal particles can be detected at the same time increasing the collection efficiency compared to various known detectors.

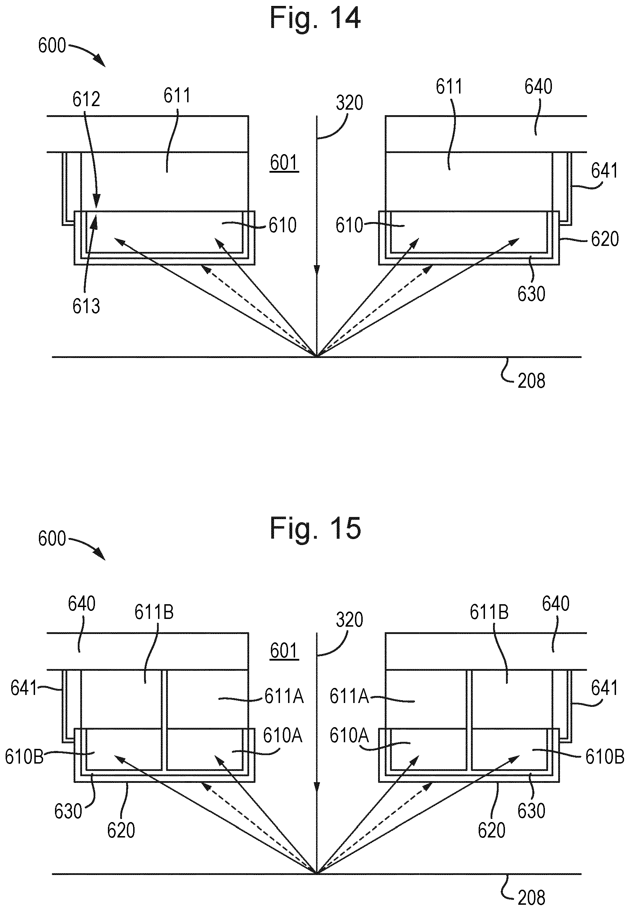

In the present invention, a detector assembly is provided which may be used in a charged particle device for an assessment tool to detect signal particles emitted by a sample in response to a charged particle beam. An exemplary version of the detector assembly 600 is shown in **FIG. 14.** The detector assembly 600 comprises a scintillator element 610 and a charge based element 620. The scintillator element 610 is configured to generate photons on interaction with signal particles above a first energy threshold. The scintillator element may emit light with a specific wavelength spectrum. The charge based element 620 configured to detect signal particles below a second energy threshold. It will be noted that the scintillator element 510 is considered in the context of the present invention as a detector element, as it is an element which detects signal particles, and converts them into photons. Thus, the detector assembly 600 comprises two different types of detector element configured to interact with the signal particles emitted from the sample. As will be understood from **FIG. 14,** the detector assembly 600 may be used with a single beam device. Thus, for example, the detector assembly could be used with the single beam device described in relation to **FIG. 9** above.

Each different type of detector element may be configured primarily to detect certain signal particles, e.g. those above or below a certain threshold. Signal particles with energies below the first energy threshold are shown with dashed line arrows in **FIG. 14** and signal particles with energies above a second energy threshold are shown with solid line arrows in **FIG. 14.** The first energy threshold may correspond to a backscatter threshold energy. Thus, the scintillator element 610 may be configured to interact with primarily backscattered signal particles. The backscatter threshold energy may the selected lowest energy level of backscattered signal particles that the detector assembly 600 is designed to detect. For example, the backscatter threshold energy may be approximately 50 eV. The second energy threshold may correspond to a secondary threshold energy. Thus, the charged based element 620 may be configured to detect primarily secondary signal particles. The secondary threshold energy may the selected highest energy level of secondary signal particles that the detector assembly 600 is designed to detect. For example, the secondary threshold energy may be approximately 50 eV.

The first energy threshold and the second energy threshold may be substantially the same. Thus, the first energy threshold and the second energy threshold may be a single predetermined value. In this case, the charge based element 620 may be used to detect any signal particles below the predetermined value and the scintillator element 610 may be used for detection of any signal particles above the predetermined value.

The charge based element 620 is positioned so that at least some of the signal particles above a first energy threshold pass through the charged based element 620 to the scintillator element 610. This can be seen by the solid line arrow representing the higher energy signal particles in **FIG. 14.** In this way, the charge based element 620 is provided between the scintillator element 610 and a detection surface of the detector assembly 600 which receives the signal particles. The charge based element 620 may form at least part of the detection surface of the detector assembly 600, as described in further detail below.

The detector assembly may further comprise or be optically connected to a photon detector 611. The photon detector 611 may be a photodiode. The photon detector could be a commercially available photon detector. The photon detector could be made of a semiconductor, e.g. a p-n photodiode, a PiN photodiode, or an avalanche photodiode. The photon detector could be a photodiode array, although the dimensions should match the pitch of the sub-beam array if for use in a multi-beam device. The photon detector 611 is configured to detect photons generated by the scintillator element 610. Preferably, the photon detector wavelength sensitivity is matched to the scintillator spectrum (i.e. the wavelength spectrum of the photons emitted by the scintillator element). The photon detector 611 may be part of the detector assembly 600. The photon detector 611 may be directly connected to a part of the detector assembly 600. Preferably, the photon detector 611 is directly connected to the scintillator element 610, for example as shown in **FIG. 14.**

The photon detector 611 may be positioned up-beam of at least part of a surface of the scintillator element 610 to receive the generated photons. In other words, the photon detector 611 may be positioned over at least part of a surface of the scintillator element 610, i.e. positioned on at least part, for example a portion, of a surface of the scintillator element 610. Therefore, the photon detector 611 and scintillator element 610 may be positioned relative to each other so that in plan view along the beam path of the sub-beam the photon detector 611 and the surface of the scintillator element 610 at least partially overlap. The photon detector 611 may be positioned on, i.e. in direct contact with, the surface of the scintillator element 610.

As shown in **FIG. 14,** the detector assembly 600 may have an aperture 601 through which a primary sub-beam 320 may pass to land on the sample 208. This is beneficial in that the detecting elements of the detector assembly 600 can surround the aperture 601 which may increase detection efficiency. More specifically, an aperture may be provided in the photon detector 611 for the passage therethrough of the sub-beam, and/or an aperture may be defined in the scintillator element 610 for the passage therethrough of the sub-beam, and/or an aperture may be provided in the scintillator element 610 for the passage therethrough of the sub-beam. Thus, various components of the detector assembly 600 may be provided with an aperture through which the sub-beam can pass.

The charge based element 620 may be provided as a layer, such as a coating. The charge based element 620 may comprise a metal layer 621. The metal layer 621 may be a planar portion. The metal layer 621 may be a thin film. Any appropriate metal may be used for the metal layer. The charge based element may have a thickness of approximately 100 nm or less, preferably approximately 10 nm to 100 nm. More specifically, the thickness of the metal layer 621 may be approximately 100 nm or less, preferably approximately 10 nm to 100 nm. Lower energy signal particles with an energy of less than 50 eV (which may correspond to the secondary signal particles described above) can be 'captured' by charge based elements with a relatively small thickness. Higher energy signal particles have a higher penetration depth. For example, signal particles having an energy of approximately 350 eV may have a penetration depth which is greater than 10 nm to 100 nm. This means that the lower energy signal particles can be captured by the charge based element 620 and the vast majority of higher energy signal particles will pass through the charge based element 620. The higher energy signal particles can be detected by the scintillator element 610 and converted into photons. Therefore, such a thickness is beneficial in allowing signal particles to effectively reach the scintillator element 610. The collection efficiency may be improved by applying a bias between the sample 208 and the detector assembly 600 to attract the signal particles to the detector elements as described below.

Use of a scintillator element may provide better timing characteristics (depending on scintillator material used). Use of a scintillator may provide better signal-to-noise than other types of detector element, especially if it is fast enough for single charged particle (e.g. electron) counting. Single charged particle counting may be desirable (e.g. due to better signal-to-noise) and more achievable for a system operating at a relatively slow scan speed (e.g. for allowing the charge-based detector to receive enough signal particles for efficient defect inspection). How many particles the scintillator detector will receive depends on the ratio between high energy (e.g. backscatter) and low energy (e.g. secondary) signal particles and if with this particle rate it is still an advantage (e.g. to avoid pile-up) to use a counting detector. In cases where the expected high energy signal particle yield is expected to be smaller than the low energy signal particle yield (e.g. for low landing energies) it may be desirable to use a single charged particle counting detector.

The scintillator element 610 may comprise inorganics e.g. alkali halides crystals with atomic (inorganic) impurities. Inorganic crystals may be mostly monocrystalline or polycrystalline. The scintillator element 610 may comprise organics, e.g. aromatic hydrocarbon compounds. Organic scintillators can be made from organic single crystals or from plastics, making it simpler to generate a specific shape or configuration. Organic scintillators may be faster (i.e. have a faster detection response to a charged particle due to their shorter light emission time). Organic scintillators may have a lower average atomic number and hence lower stopping power for particles, i.e. a poorer ability for stopping particle. (However, the lower stopping power has little significant impact for the relatively low kinetic energies of the signal particles considered here, which tend to have a maximum energy of approximately 30 keV). Theoretically, the scintillator element 610 may comprise organics and inorganics, however, such a combination may be unlikely.

The scintillator element may optionally comprises a photon reflection surface configured to reflect photons with an elevated efficiency. Preferably the photon reflection surface is a surface of the scintillator element 610 treated, e.g. by polishing, grinding, etching, and/or chemical treatment, to improve photon reflection in the scintillator element 610. The photon reflection surface may have a structured or textured surface to improve (or increase) reflection. For example the structure on the surface may relate to the wavelength of the scintillation light generated by the scintillator. Any of the scintillator surfaces may be a photon reflection surface. Preferably, the surfaces facing away from the photon detector 611 are photon reflecting surfaces, e.g. the surfaces adjacent to the reflective element 630 (described below) and/or the charge based element. This is beneficial as is may improve, or even optimize, reflection of the photons within the scintillator in a desired direction, e.g. towards the photon detector 611 (if provided) or other appropriate optical component.

It is noted that scintillators and PIN detectors are typically capable of detecting charged particles above a detection threshold for example typically above approximately 1kV, although lower values for example 200eV for PIN detectors are known. For a scintillator the detection threshold may be varied by the selection of the thickness of a conductive coating, such as a metal layer, on the scintillator surface. The charge based element may provide such a conductive coating. Alternatively, another form of conductive coating, which may or may not be metal, could be provided on the scintillator. Signal particles that pass through the charged based element might not be detected by the scintillator if their energy is below a minimum energy detection threshold of the scintillator element.

Preferably, the charge based element 620 and the scintillator element 610 are each at least part of layers that are substantially co-planar with the major surfaces of the detector assembly (i.e. the detection surface). The detection surface is the surface of the detector assembly for passage of the signal particles to the scintillator element 610 and/or the charged based element 620. It will be understood that the layers of detector elements, such as the charge based element 620 and the scintillator element 610 are different portions of the layered detector structure.

In an embodiment, the detector elements may be provided as layers, i.e. layered portions, of a stacked structure comprised in the detector assembly 600 stacked in a thickness direction of the detector assembly. The stacked layers of the charge based element 620 and the scintillator element 610 are shown in **FIG. 14.** The layers of the charge based element 620 and the scintillator element 610 are stacked in a direction of the primary beam 320. Any of the detector elements may be stacked in the thickness direction of the detector assembly 600, including the scintillator element 610 and the charge based element 620, as well as other optional features such as the photon detector 611 and/or other components described further below.

Preferably, the charge based element 620 is positioned down beam of the scintillator element. Preferably, the charge based element 620 is closer to the detector surface than the scintillator element 610. Specifically, the metal layer 621 of the charge based element 620 is preferably closer to the detection surface than the scintillator element 610, or the metal layer 621 may form the detection surface. Generally, the higher energy signal particles when impacting (i.e. hitting) the detection surface, can be detected at the scintillator element 610 through the charge based element 610.

Providing the detector elements stacked on top of each other is beneficial because the detector elements can make use of the complete available detection efficiency by using the full detection area available for the detector assembly 600. In general it is important to separate the secondary signal particles (i.e. the low energy signal particles) and the backscatter signal particles (i.e. the high energy signal particles). This is because typically more secondary signal particles are produced at the sample than backscatter signal particles which causes the secondary signal particles to dominate the signal if the signal particles are not well separated. The stacked detector elements can separate the signal particles based on the energy difference and the difference in penetration depth. Specifically, the low energy signal particles corresponding to the secondary signal particles are captured by the charge based element 620. However, the high energy signal particles will penetrate the charge based element 620 to generate photons in the scintillator element 610. Thus, the higher energy signal particles can be detected in the scintillator element 610 after having travelled through the charge based element 620. Thus, the stacked detector allows separate detection of the lower energy signal particles at the charge based element 620. The stacked detector permits detection of the higher energy signal particles at the scintillator element 610 simultaneously. These improvements in function are beneficial for improving detection efficiency.

As indicated above, the detection surface may be a surface of the detector assembly configured to receive the signal particles which are emitted from the sample 208. The detection surface may be the first surface contacted by the signal particles. The signal particles may pass through the detection surface so as to interact with the detector elements. The detection surface may be at least part of an outermost surface of the detector assembly. In use, the detection surface may face in the direction of the sample 208 (although this is not a necessity, for example in a mirror array as described above in relation to **FIG. 7**). The detection surface may directly face the sample, i.e. may be adjacent to the surface of the sample 208.

The charge based element 620 may provide at least part of the detection surface of the detector assembly, preferably substantially the whole detection surface. In other words, the charge based element 620 may be an outermost layer of the detector assembly 600, as shown in **FIG. 14.** The metal layer 621 may form the detection surface. As shown in **FIG. 14,** the metal layer 621 may form substantially the whole detection surface.

As shown in **FIG. 14,** the charge based element 620 may form a layer over substantially the whole exposed part of the scintillator element 610, i.e. over at least over several sides of the scintillator. This means that the charge based element 610 is provided over the whole surface of the scintillator element 610 unconnected to another component, such as the photon detector 611 (or photon guiding element described below). Such a charged based element 610 may form substantially the whole detection surface. In particular, the metal surface layer 621 of the charge based element 620 may form substantially the whole detection surface, as shown in **FIG. 14.**

The detector assembly 600 may comprise a reflective element 630. The reflective element 630 may be positioned over at least a portion of the scintillator element 610. That is the reflective element 630 may be on at least a portion of the scintillator element. The reflective element 630 might be provided on at least one planar side of the scintillator element 610 orthogonal to the primary beam path. The reflective element 630 might be provided on only planar sides of the scintillator element 610 not between on the lateral sides of the detector assemblies. The reflective element 630 is configured to reflect within the scintillator element 610 photons generated in the scintillator element 610. This is beneficial as it may improve, or even optimize, reflection of the photons within the scintillator in a desired direction, e.g. towards the photon detector 611 (if provided) or other appropriate optical component. This may be beneficial in avoiding photons leaving the scintillator via other surfaces of the scintillator element 610, which would be lost before detection; that is such lost photons would not be detected. The reflective element may serve to improve efficiency of detection of photons generated by the scintillator. The reflective element may optimize yield of photons by the scintillator element 610 and may improve the signal-to-noise ratio.

The reflective element 630 may be provided as a layer, such as a coating. The reflective element 630 may be a planar portion. The reflective element 630 may be a thin film. The reflective element 630 may be provided in any form or shape. The reflective element may comprises thin tape (e.g. Teflon tape), thin foils and/or reflective paint (e.g. titanium-dioxide). The reflective element 630 may extend between the charge based element 620 and the scintillator element 610. The reflective element 630 may be of any appropriate thickness. Preferably, the reflective element 630 is not too thick to avoid that higher-energy charged particles cannot penetrate it and do not reach the scintillator element 610.

The reflective element 630 may be provided as a layer wrapped (preferably not too tightly) around the scintillator element 610 to improve reflection of the light photons. By this wrapping a small air (or vacuum) layer can be created between the scintillator element 610 and the reflective element 630 which can lead to a large reflection efficiency (due to the large difference in breaking index between the scintillator element 610 and air (or vacuum)). Photons that do get out of the scintillator element 610 can then be reflected back to the scintillator element by reflection from the wrapped reflective element 630 itself.

Preferably, the charge based element is positioned over the reflective element, e.g. as shown in **FIG. 14.** As described above, the charged based element may provide the detection surface. The reflective element 630 may be positioned between the charge based element 620 and the scintillator element 610, e.g. as shown in **FIG. 14.** Thus, at least part of the scintillator element 610 and the charge based element 620 may be separated from each other by the reflective element 630. Although the reflective element 630 is shown as separating the scintillator element 610 and the charge based element 620, the reflective element 630 may be provided over a part of (rather than the whole) scintillator element 610. For example, the reflective element 630 could be provided as a planar layer parallel to the main part of the detection surface facing the sample 208.

The reflective element 630 may have any appropriate thickness (i.e. in the thickness direction of the stacked detector elements, e.g. in a direction of the primary beam) between other components, e.g. between the metal layer 621 and the scintillator element 620. For example, the thickness may be between approximately 10 to 500 nm, and preferably between approximately 50 to 500 nm.

Although the reflective element 630 may beneficially improve photon collection, it is not a necessity. In this case, the charge based element 620 may be in direct contact with the surface of the scintillator element 610. The scintillator element 620 is preferably non-conducting and preferably inert.

The detector assembly may comprise a circuitry layer 640 comprising the detector circuitry. The circuitry layer 640 may comprise some, if not all, of the circuitry used to process the signals from the different detector elements. Thus, the circuitry layer 640 may convert the detected signal particles into electrical signals. The circuitry layer 640 may comprise various different electrical components. The circuitry layer may be connected to the charge based element 620 and the photon detector 611 as described below. The circuitry layer may comprise parallel layers of circuitry for connecting to each of the charge based element 620 and the photon detector 611. Alternatively, the circuitry layer may comprise a single layer with circuitry adjacent in cross-section for connecting to each of the charge based element 620 and the photon detector 611.

Providing the circuitry layer 640 in the detector assembly is beneficial in that the circuitry can be close to the detector elements. The detector elements are connected to circuitry to convert the detected signals into a digital signal. In general, having circuitry for converting the detected signal into a digital signal as close as possible to the relevant detector element beneficially improves the digital detection signal. A proximate digitization circuitry reduces risks of loss or at least deterioration of or disruption to the detection signal.

The charge based element 620 is preferably in electrical communication with detector circuitry (preferably comprised in the circuitry layer 640). Preferably, the charge based element 620 is electrically connected to the detector circuitry. Preferably the electrical communication comprises electrical contact, for example as an electrical connector 641 (e.g. a via) between the charged based element 620 and the detector circuitry. Thus, the detector assembly 600 may comprise electrical connector 641 configured to connect the charge based element 620, and particularly the metal layer 621, to detector circuitry. That is, the electrical connector 641 is for the detector assembly to detect a signal particles through connection to the charge based element 620. The electrical connector 641 is preferably positioned external to the scintillator element 610, as shown in **FIG. 14,** although the electrical connector 641 could be provided as a via through the scintillator element 610, e.g. through a hole in the scintillator element 610. Thus, the charge based element 620 may be connected to the circuitry layer 640 by an electrical connection along the electrical connector 641. This means that the charge based element 620 may be used to form the detection surface, or at least part of the detection surface, whilst still being appropriately connected to the circuitry of the detector assembly.

The photon detector 611 is preferably in electrical communication with detector circuitry (preferably comprised in the circuitry layer 640). Preferably, the photon detector is electrically connected to the detector circuitry. The photon detector 611 may be directly connected to the detector circuitry, as shown in **FIG. 14.**

As described in further detail below, the circuitry layer 640 may comprise or be connected to the circuit layer and/or wiring as described above in relation to **FIGS. 10, 11, 12, and 13.** For example, the detector circuitry may comprise a transimpedance amplifier 556 and/or an analog to digital converter 558 in electrical communication with the charge based element 620. Preferably, the transimpedance amplifier 556 and/or an analog to digital converter 558 is electrically connected to the charge based element 620. The detector circuitry may comprise a transimpedance amplifier 556 and/or an analog to digital converter 558 in electrical communication with the photon detector 611. Preferably, the transimpedance amplifier 556 and/or an analog to digital converter 558 is electrically connected to the photon detector 611. Such a transimpedance amplifier 556 and analog to digital converter 558 (as well as other relevant electrical components) are described above in relation to **FIGS. 10A, 10B, 10C, 11, 12 and 13.** It is noted that the size available for the detector elements is relatively small. Thus, it is beneficial to provide an amplifier, such as the transimpedance amplifier. However, some amplifiers such as the transimpedance amplifier generally need a large resistance. Thus, the circuitry may be provided with wiring routed between cells as described in relation to **FIG. 10A.** This allows the signal to be amplified so that the noise is small. Additionally or alternatively, a pseudo resistor may be used with the transimpedance amplifier, and/or an analog to digital converter as described in relation to **FIGS. 12 or 13.**

Although it is described above that the first energy threshold and the second energy threshold are substantially the same, they may have an offset. In other words, the first energy threshold may differ from the second energy threshold. For example, it may be noted that detection of signal particles near the threshold might result in detection of various different types of signal particle and it may be preferable to more clearly separate detection of the different signal particles. Having an offset between the first energy threshold and the second energy threshold may reduce the signal particles detected, and may specifically reduce the amount of signal particles with borderline energy levels which may decease noise in the detection. The first energy threshold may be more, i.e. larger in magnitude, than the second energy threshold. The first energy threshold may depend on the layer thicknesses before reaching the scintillator element 610. However, it can be tuned somewhat with the bias voltage between the sample and the detector assembly (described further below as the potential different between the sample and detector assembly). If the bias voltage is, for example, +200 V instead of +50 V, then effectively lower backscatter signal particles might gain sufficient additional kinetic energy to pass these layers, thereby lowering the effective first energy threshold. Something similar happens with the second energy threshold. Therefore, the values for the threshold can be influenced by the bias voltage, and therefore the difference between the first and second threshold could be between approximately 0 and 200 V.

It will be understood from the description of the secondary and backscatter signal particles above that the threshold value (e.g. of 50 V, or 100 V, or 200 V) between the different types of signal particles is arbitrary. There is not a black and white division around (i.e. distinct separation at) this threshold. The precise selection of the threshold value is unlikely much to improve or contribute to the image contrast or quality. Thus, the selection of the threshold value is unlikely to reduce the detection of signal particles with borderline energy levels. In general it is expected that the effective first and second energy thresholds may be different because of the energy loss in the layers between the metal layer 621 and the scintillator 610. A signal particle that has just enough energy to leave the metal layer 621 (i.e. above the first energy threshold) might lose too much energy in the layers that are in between metal layer 621 and the scintillator element 610 to reach the scintillator element 610; thus leading to a second energy threshold having a different value from the first energy threshold.

As described above, the aperture 601 is defined in the detector assembly for the passage therethrough of a charged particle beam. This is beneficial in that the beam (e.g. primary beam 320) may pass through the detector assembly 600 such that signal particles can be captured by the detector assembly 600 all the way round the primary beam. However, although this is beneficial, other configurations may also be used. For example, the detector assembly 600, or at least the detection surface of the detector assembly, may be provided to one side of the primary beam path. This would allow the primary beam to reach the sample 208, and the detector assembly 600 can still detect signal particles emitted from the sample 208. In this configuration, a Wien filter may be used in combination with the detector assembly. In another configuration the detector assembly may be provided as at least two portions either side of the path of the primary beam. The two portions may be separated by a gap. The two portions may be spaced apart. The gap may take the form a slit or strip through which the path of the primary beam passes. If multiple primary beams (e.g. sub-beams) are provided, then the detector assembly may still be provided to one or both sides, for example, with slits for paths of the multiple sub-beams of the primary multiple multi-beams. In an embodiment, such a detector arrangement may have multiple detector assemblies on one side of the slit. Such an configuration featuring a slit between detector assemblies or detector portions may be easy to manufacture. However, providing the detector assembly with an aperture formed therein may be beneficial in allowing for a larger detection surface which may thus increase the detection efficiency. Locating the detector assembly on a lens electrode, within an electrostatic lens may easier to achieve if such a detector assembly has an aperture rather than a slit or the like. It is noted that the aperture of the detector assembly in an electrostatic field may cause some disturbance of the field which may affect the primary sub-beam and it is preferable if the disturbance of the sub-beam is symmetric, because it leads to less deformation by aberrations.

As described above in relation to **FIGS. 6A and 6B,** it may be beneficial to provide a zoned detector assembly because this means that additional information can be determined relating to the detected signal particles. The detector assembly 600 may have zoned portions as described in relation to **FIGS. 6A and/or 6B.**

More specifically, the photon detector 611 may comprise zoned photon detector portions. The photon detector portions may be separated in a variety of different ways, e.g. radially, annular, or any other appropriate way. Preferably the portions are of similar angular size and/or similar area and/or similar shape. The separated photon detector portions may be provided as a plurality of segments, a plurality of annular portions (e.g. a plurality of concentric annuli or rings), and/or a plurality of sector portions (i.e. radial portions or sectors). The photon detector portions may comprise an inner photon portion 611A and an outer photon portion 611B. The photon detector portions are preferably concentric and radially divided from each other. For example, as shown in **FIG. 15,** the photon detector may comprise an inner annular portion 611A surrounding the aperture and an outer annular portion 611B, radially outwards of the inner annular portion 611A. Although two annular portions are shown in **FIG. 15,** the photon detector may be provided as annular portions comprising any appropriate number of portions, e.g. 2, 3, 4, or more portions. Additionally or alternatively, the photon detector comprises zoned portions which are sectors, which are preferably angularly divided from each other. For example, the photon detector may be provided as sectors (i.e. sector portions) comprising 2, 3, 4, or more portions, for example 8, 12 etc.. If the photon detector is provided as two sectors, each sector portion may be a semi-circle. If the photon detector is provided as four sectors, each sector portion may be a quadrant (for example as shown in **FIG. 6B**). Alternatively, the photon detector may be provided with at least one segment portion. The photon detector portions may be separated both radially and angularly or in any other convenient manner.

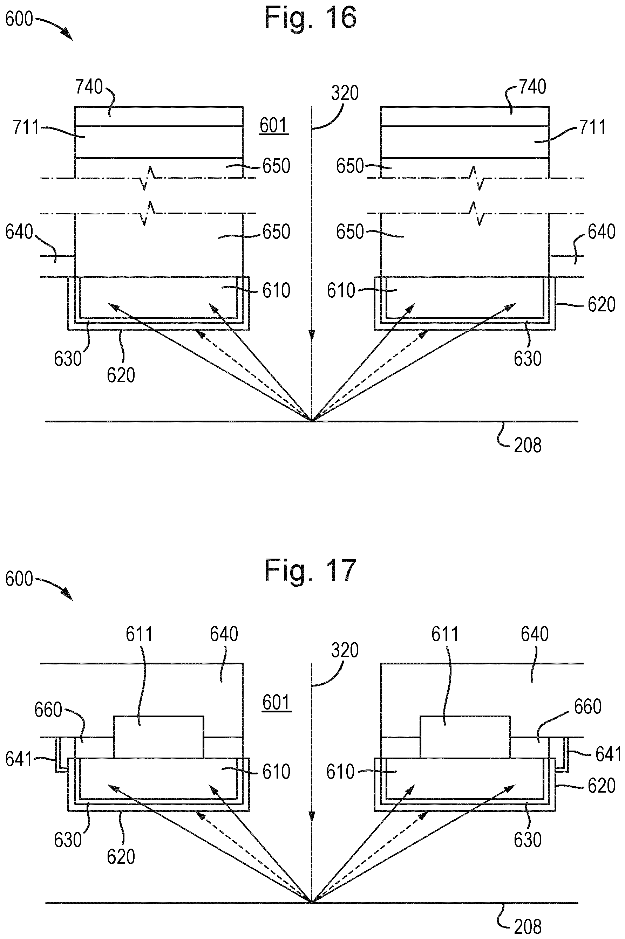

The separate photon detector portions may be electrically insulated from each other. In **FIG. 16**, it is shown that the reflective element extends between the inner annular portion 611A and the outer annular portion 611B. Although the reflective element 630 may comprise a protrusion which extends between the photon detector portions, separating them from each other. A separate electrically insulating member (not shown) could be provided between the photon detector portions in order to electrically isolate the photon detector portions from each other. Each photon detector portions may be separated by an electrically insulating member.

The scintillator element 610 may be provided as separate zoned portions, preferably wherein the zoned portions of the scintillator element correspond to the zoned portions of the photon detector.

In further detail, the scintillator element may comprise zoned scintillator portions. The scintillator portions may be separated in a variety of different ways, e.g. radially, annular, or any other appropriate way. Preferably the portions are of similar angular size and/or similar area and/or similar shape. The separated scintillator portions may be provided as a plurality of segments, a plurality of annular portions (e.g. a plurality of concentric annuli or rings), and/or a plurality of sector portions (i.e. radial portions or sectors). The scintillator portions may comprise an inner scintillator portion 610A and an outer scintillator portion 610B. The scintillator portions are preferably concentric and radially divided from each other. For example, as shown in **FIG. 15**, the scintillator may comprise an inner annular portion 610A surrounding the aperture and an outer annular portion 610B, radially outwards of the inner annular portion 610A. Although two annular portions are shown in **FIG 15**, the scintillator may be provided as annular portions comprising any appropriate number of portions, e.g. 2, 3, 4, or more portions. Additionally or alternatively, the scintillator comprises zoned portions which are sectors, which are preferably angularly divided from each other. For example, the scintillator may be provided as sectors (i.e. sector portions) comprising 2, 3, 4, or more portions, for example 8, 12 etc.. If the scintillator element is provided as two sectors, each sector portion may be a semi-circle. If the scintillator element is provided as four sectors, each sector portion may be a quadrant (for example as shown in **FIG. 6B**). Alternatively, the scintillator element may be provided with at least one segment portion. The scintillator element portions may be separated both radially and angularly or in any other convenient manner.

The separate scintillator element portions may be optically insulated from each other. This is beneficial in reducing or preventing photons generated in one scintillator portion travelling via internal reflection to another scintillator portion. In **FIG. 15**, it is shown that the reflective element extends between the inner annular portion 610A and the outer annular portion 610B. The reflective element 630 is shown in **FIG. 15** with a protrusion which extends between the scintillator portions and the photon detector portions, separating them from each other. The reflective element 630 may only extend between the scintillator portions (i.e. may not be provided between the photon detector portions). The reflective element 630 is shown as a single integral member provided over surfaces of the scintillator portions. The reflective member 630 may comprise several components over different parts of the scintillator portions, e.g. a reflective portion between adjacent scintillator portions. The reflective member (or reflective portions) may only be provided between adjacent scintillator portions. Each scintillator portion may be separated by a reflective portion.

Providing zoned photon detector portions with corresponding zoned scintillator portions is beneficial because it allows emission angles of emitted signal particles to be resolved. It is beneficial to provide both the photon detector and scintillator portions in corresponding zones because otherwise the light photons created in the scintillator can travel via internal reflections to any of the angularly divided photon detectors.

The charge based element 620 may provide a unitary detector surface (as shown in **FIG. 15**, and which is the same as the charge based element 620 described in relation to **FIG. 14**). This may be desirable to optimize the detection efficiency of the secondary signal particles because the characteristics of such signal particles are independent of angular trajectory. Alternatively the charged based element may have a similar arrangement of zoned detector portions as the zoned scintillator portions. In an embodiment the zoned detector surface 620 may take any desired pattern dependent or independent of the zoned scintillator portions.

It is described above that the photon detector 611 is preferably directly connected to the scintillator element 610. However, other configurations are also possible. As previously mentioned, the photon detector 611 may be a remote photon detector 711, i.e. which is not connected to other parts of the detector assembly 600. For example, the photon detector 611 may not be in direct contact with the scintillator element 610. The photon detector 711 may still be part of the detector assembly 600, however, the detector assembly 600 could be a distributed system where the components are not in physical contact. Alternatively, the remote photon detector 711 may be a component external to the detector assembly 600.

The remote photon detector 711 may be indirectly connected to the scintillator element 610. In an embodiment, the detector assembly 600 may comprise a photon guiding element 650 (which may otherwise be referred to as a light guide) configured to transport photons generated by the scintillator element 610 away from the scintillator element 610, for example, as shown in **FIG. 16**. The photon guiding element 650 may have any appropriate shape in cross-section in order to provide efficient transport of photons from the scintillator element 610, e.g. to the photon detector. The photon guiding element 650 may be specially shaped to optimize the photon transport from the scintillator element 610 to the photon detector 620. The photon guiding element 650 may be any appropriate material, e.g. glass or an organic material such as plastic which is transparent to the photons emitted by the scintillator such as a transparent thermoplastic; such a material may referred to as be plastic glass.

Preferably, the photons are transported to the photon detector 711 remote from the scintillator element 610, i.e. spaced apart from the scintillator element 610. As shown in **FIG. 16,** the photon guiding element 650 may be directly connected to the scintillator element 610 at one end of the photon guiding element 650. The photon guiding element 650 may be directly connected to the remote photon detector 711 at the other end of the photon guiding element 650. The photon guiding element 650 may be any appropriate optical element. The photon guiding element 650 may comprise optic fibre. Although other photon guiding elements may be provided, particularly for any ringshaped scintillator elements 610. Such an application may also feature a detector array up beam of an objective lens array. A Wien filter array may direct the signal particles towards the detectors located between the primary beam path. Photon guiding elements 650 may direct the photons generated in the scintillator the photon detector which may be spaced apart within the charged particle column or even remote from the charged particle column. Such a spaced apart detector or a remote photon detector 711 may be connected to a further circuitry layer 740. The further circuitry layer 740 may be in electrical communication with the circuit layer 640, although this is not a necessity and independent signals may be sent separately by the circuitry layer 640 and the further circuitry layer 740. The further circuitry layer 740 may comprise an amplification circuit as described below.

It will be noted that the photon guiding element 650 is shown in **FIG. 16** with a configuration of the detector assembly 600 which is similar to **FIG. 14.** The photon guiding element 650 could also be provided in combination with variations shown and described above in relation to **FIG. 15.** In this instance, the photon guiding element 650 may be provided as multiple photon guiding portions, with each portion corresponding to a respective zoned portion of the scintillator element 610 and a respective zoned portion of the photon detector 611.

The photon detector 611 may cover the surface of the scintillator 610 which is not covered by the reflective element 630 (or charge based element 620), as shown in **FIG. 14.** The photon detector 611 may have a single surface sensitive to light (i.e. a photon detection surface), which is preferably coupled to the scintillator element 610 as shown in **FIG. 14** (or is coupled to the light guiding element as shown in **FIG. 16**). As shown in **FIG. 14,** the photon detection surface 612 is preferably configured to cover the surface 613 of the scintillator through which photons travel from the scintillator towards the photon detector 611. This is beneficial as if any of the scintillator is exposed, for example to the ambient environment (i.e. not covered by the components provided, e.g. the photon detector 611, the reflective element 630, the charge based element 620, or the light guiding element 650) may allow stray light to enter into the scintillator. Such stray light that entered the scintillator may then be detected by the photon detector 611, especially if the stray light is of a similar wavelength to the photons generated by the scintillator. Stray light within the scintillator may erroneously be detected as a photon generated based on interaction with a signal particle.

However, the photon detector 611 may cover a whole side of the scintillator as shown in **FIG. 14.** Instead, the photon detector 611 may be positioned over only part of a surface of the scintillator. That is the photon detector 611 may have a smaller cross-section in plan view with respect to a primary beam path than the scintillator element 610 (i.e. in a cross sectional plane orthogonal to the primary beam path). For such a photon detector 611, the detector assembly 600 may further comprise a light shield 660 positioned so as to shield at least part of the scintillator element to prevent stray light from reaching the scintillator element and/or the photon detector 611, for example as shown in **FIG. 17.** The light shield 660 may be provided as a layer, such as a coating. The light shield 660 may be of any appropriate material and thickness to prevent light passing through the light shield 660, e.g. any material that completely absorbs or reflects light photons with wavelengths that the photon detector is sensitive for. For example, the light shield could be a thin metal layer, or a plastic material (e.g. black and flexible to give a good closing ,such as a rubber ring or so) or a non-transparent adhesive or glue etc..

Preferably the light shield 660 is positioned up-beam of the scintillator element 610. Although the light shield 660 may be provided on any portion of the scintillator which might otherwise be exposed. Preferably the light shield 660 is provided around the photon detector 611 as shown in **FIG. 17,** e.g. surrounding the photon detector 611 in plan view. The light shield 660 and the photon detector 611 may be positioned relative to each other so that in plan view along the beam path the light shield 660 and the photon detector 611 cover a surface of the scintillator element 610. Preferably the light shield 660 and the photon detector 611 cover, at least in plan view, the surface of the scintillator element not covered by the reflective element 630 and/or the charge based element 620.

The scintillator element is preferably fully covered, e.g. by the photon detector 611, the charge based element 620, the reflective element 630, and/or the light shield 660 (depending on which components are provided). Effectively, the light shield 660 may be a member used to shield a part of the scintillator not covered by other components, such as the photon detector 611, the charge based element 620, and the reflective element 630, in order to prevent stray light from entering into the scintillator element 610.

Although the light shield 660 is shown on a surface of the scintillator, the light shield may additionally or alternatively be used to prevent stray light from entering into the photon detector 611. For example, the detecting surface of the photon detector 611 may be larger than the scintillator element 610. For example, the photon detector 611 may overhang the scintillator element 610 and may thus extend over the edge of the scintillator element. This might mean that the detection surface of the photon detector 611 is not covered by the scintillator element and could detect stray light. Thus, the light shield 660 could be positioned on the surface of the photon detection element to prevent stray light from reaching the photon detection element. In other words, the light shield 660 may be provided on any detecting portion of the photon detector 611 which might otherwise be exposed.

It will be noted that the light shield 660 is shown in **FIG. 17** with a configuration of the detector assembly 600 which is similar to **FIG. 14.** The light shield 660 could also be provided in combination with variations shown and described above in relation to **FIG. 15.** In this instance, the light shield 660 may be provided as multiple light shielding portions, with each portion corresponding to a respective zoned portion of the scintillator element 610 and/or a respective zoned portion of the photon detector 611. The light shield 660 may be provided between separate zoned scintillator portions and/or separate zoned photon detector portions. Additionally or alternatively, the light shield 660 could be provided in combination with the photon guiding element 650, for example as described in **FIG. 16.** The light shield 660 may be provided on any surface of the photon guiding element which may be sensitive to light.

The light shield 660 may be configured to shield the photon guiding element 650, the scintillator element 610 and or the photon detector 611. The light shield 660 may be provided in multiple portions, depending on which part(s) of the detector assembly are to be shielded from stray light.

Although the charge based element 620 is shown in the figures as providing the whole detection surface, the charge based element 620 may not form substantially the whole detection surface. Thus, the charge based element 620 may only partially cover the scintillator element 610 and/or the reflective element 630 (if provided). For example, the charge based element 620 may only be provided on an inner part of the detector assembly 600, e.g. as an annulus surrounding the primary beam, or another shape which is on a radially inner part of the detection surface. It is possible that the lower energy signal particles (e.g. secondary signal particles) generally have trajectories which are closer to the primary beam path. Thus, such a charge based element 620 may still detect the majority of the lower energy signal particles as there may not be many (if any) lower energy signal particles impacting the detection surface radially outwards of the charge based element 620. This may reduce the material required for the charge based element. In this case, the charged based element 620 provides part of the detection surface and another component, e.g. the scintillator element 610 and/or reflective element 630 and/or the light shield 660 may provide at least part of the detection surface. In other words, the detection surface comprises may comprise the scintillator element 610 and/or the reflective element 630 and/or the light shield 660 in combination with the charge based element 620. Although this is possible, it is preferred to provide the charge based element 620 covering the scintillator element, and at least covering a surface of the scintillator configured to face the sample (which is parallel to the main detection surface of the detector assembly). This is because the charge based element 620 is preferably provided to cover as large an area as possible to improve detection efficiency of the lower energy signal particles. The configurations of the charge based element 620 and other detecting elements, such as the scintillator element 610 and/or the reflective element 630 (if provided), may be similar to the description in relation to **FIGS. 6A and/or 6B** above.

Although the reflective element 630 is shown in the figures, this feature is optional and may not be included. In this case, the scintillator element 610 and the charge based element 620 may be in direct contact. The scintillator element 610 and the charge based element 620 being in direct contact will influence the reflection properties of this contact surface which may be beneficial for the overall detection efficiency. The reflective element 630 may be provided, but only on part of the scintillator. Thus, for example, the reflective element 630 may be provided between part of the scintillator element 610 and the charge based element 620, and another part of the scintillator element 610 and the charge based element 620 may be in direct contact. The scintillator element 610 and the charge based element 620 may be at least partially separated from each other by components other than the reflective element 630.

Preferably, any parts of the detector assembly visible to the sub-beam, e.g. surrounding aperture 601, are conducting to prevent charging effects. This may apply to the inner surface of the detector when aperture 601 is provided as shown in **FIGS. 14-17**. Specifically, this may apply to an inner surface of the charge based element 620 when provided as shown in these figures.

The detector assembly 600 as described in any of the above variations can work both with decelerating and accelerating objective lenses (i.e. with the device working in a decelerating or an accelerating mode). In particular, when the detector assembly 600 is positioned as a bottom detector (e.g. down-beam of the objective lens array 241), the signal particle trajectories towards the detector assembly 600 are determined by the field between the sample and the detector assembly 600, not by the decelerating or accelerating field of the objective lens. By applying negative or positive bias on the detector assembly 600 (or detector arrangement) with respect to the sample, low energy signal particles (e.g. secondary signal particles) can either be repelled (backscatter-only mode) or attracted (combined secondary and backscatter mode). It is noted that higher landing energies are typically used with the accelerating lens. This means that the high energy signal particles (e.g. the backscatter signal particles) have higher energies on average in this case. This makes it easier for the high energy signal particles to pass through the charge based device 620 and the reflective element 630. The high energy signal particles may thus reach the scintillator element 610 in such a layered detector with more ease. This detector type is even more attractive for accelerating lenses.

The detector assembly 600 described above may be used in a single charged particle beam device, e.g. in combination with the device described in relation to **FIG. 9.** Alternatively, multiple detector assemblies could be used in a multi-beam device, e.g. in which a primary beam is separated into sub-beams, for example as described in relation to **FIGS. 3 and 8**. Thus, multiple detector assemblies may be provided which may be suitable for use in a multi-beam charged particle device. The multiple detector assemblies could be provided as described in any of the above variations or embodiments. The multiple detector assemblies may form an arrangement which may be referred to as a detector array and may be used as the detector array 240 described in any of the above variations.

In the detector arrangement, each detector assembly 600 may be configured as described above and may be positioned adjacent to other detector assemblies in an array. Each detector assembly may correspond to a respective charged particle beam (i.e. one of the sub-beams of the array of primary beams). Each of the detector assemblies may have the same configuration as each other, e.g. with all the detector assemblies having a detector element configuration as shown in **FIG. 14,** or the configuration as shown in **FIG. 15,** or the configuration as shown in **FIG. 16,** or the configuration as shown in **FIG. 17.**

The detector assemblies forming the detector arrangement may comprise photon detectors 611, as described above. Specifically, the detector arrangement may comprise an array of photon detectors 611 configured to detect photons generated by the scintillator elements 610. The array of photon detectors 611 may be formed in a body with other components such as the scintillator elements 610 and the charge based elements 620, e.g. as shown in **FIG. 14,** to provide the detector arrangement. Alternatively, the detector arrangement may comprise remote photon detectors 711 which may be spaced apart from the main body of the detector arrangement (the main body preferably comprising the scintillator elements 610 and/or the charge based elements 620 and/or the reflective elements 630 and/or the detector circuitry 640).

The detector arrangement may comprise an array of scintillator elements configured to generate photons on interaction with signal particles above an energy threshold (e.g. corresponding to the first energy threshold described above), an array of photon detectors 611 configured to detect photons generated by the scintillator elements, and an amplification circuit associated with each photon detector 611 and proximate to the corresponding photon detector 611, the amplification circuit comprising a Trans Impedance Amplifier and/or an analogue to digital converter. The amplification circuit is described further below. Although such a detector arrangement may be provided with charged based elements 620 as described above, the detector arrangement may be provided without the charge based elements. Thus, for example, the detector arrangement may comprise detector assemblies as described above including a Trans Impedance Amplifier and/or an analogue to digital converter and without the charge based elements.

The arrangement of detector assemblies may be arranged in any appropriate configuration. Each detector assembly may correspond to a respective sub-beam 320. For example, the detector assemblies being arranged in an arrangement may correspond to the array of sub-beams of the multi-beam array described above. The arrangement may be a hexagonal (see for example **FIG. 10A**) or rectilinear grid. More particularly, certain components of the detector assemblies, such as the scintillator elements 610 may be arranged in an array corresponding to the array of charged particle beams, such a hexagonal (see for example **FIG. 10A**) or rectilinear grid, such as a rectangular or square grid.

The detector arrangement may have a plurality apertures for the passage of a respective charged particle beam (i.e. a sub-beam) or a group of charged particle beams. Thus, the apertures of the plurality of detector assemblies may be for the passage therethrough of at least one sub-beam of the multi-beam array towards the sample 208. More specifically, the scintillator elements and/or photon detectors and/or charge based elements may comprise apertures for the passage of a respective charged particle beam or a group of charged particle beams. Of course, this will depend on how these components are arranged. In a detector arrangement a plurality of apertures are defined in the detector arrangement in which each aperture corresponds to at least part of one or more rows or columns of beams across the multi-beam array. The apertures may be elongate. Such an aperture arrangement may be suited for use with a Wein filter array for defecting signal particles towards detector elements of the detector arrangement between the apertures. In the variations shown in **FIGS. 14, 15, 16, 17,** each of the scintillator elements and photon detectors and charge based elements comprise apertures for the charged particle beam(s). If the photon detector elements are positioned remotely to the scintillator elements, they may be away from the primary beam paths. In this case, the photon detector elements may not comprise apertures.

As described above, at least some of the components of the detector assemblies may be provided in a detector arrangement which is provided to a side of the primary beam path, e.g. on a side of a slit for the paths of the multiple sub-beams, as described above. In this case, the components of the detector arrangement may not comprise apertures as the sub-beams may pass to the side of, rather than through, the detector arrangement.

If an arrangement of detector assemblies is provided, which may otherwise be referred to as an array of detector assemblies 600, multiple detector assemblies may be provided with at least one component of the detector assemblies in a common body. The body may comprise a plurality of scintillator elements 610 and a plurality of charge based elements 620. Each scintillator element 610 is associated with a corresponding one of the charge based elements 620. The same body may be provided for all the detector assemblies 600 in the arrangement. Alternatively, multiple bodies may be provided for the detector arrangement, with each body comprising a plurality of scintillator elements 610 and a plurality of charge based elements 620. The number of scintillator elements 610 may correspond to the number of charged based elements 620.

There may be components or layers of the detector assemblies which form a common layer, i.e. which are formed in the same position in each detector assembly 600 of the array. For example, one of the components or layers, e.g. the metal layer 621 of the charge based element, may be formed for each of the detector assemblies in the same position along the primary beam paths. In the case of the metal layer 621, the metal layer 621 may be formed as a detection surface for each of the detector assemblies forming the detector arrangement.

The scintillator element 610 of each detector assembly may be in a common scintillator layer of the body. Thus, the body may comprise a scintillator layer comprising the plurality of scintillator elements 610. At least one scintillator is provided for each separate scintillator element, which may for example have optically insulating material (e.g. similar to the reflective element 630) between scintillator element elements of different detector assemblies in the arrangement. In other words, the scintillator may be provided as separate scintillator elements mounted in different material. In this case, the electrical connectors 641 may easily be positioned external to the individual scintillator elements 610. Alternatively, the scintillator elements could be provided as a continuous layer, i.e. with the same scintillator common to multiple detector assemblies. In other words, a single scintillator (which may otherwise be referred to as an integral scintillator) may be used to provide multiple scintillator elements, i.e. for multiple detector assemblies. In this case, some form of light reflecting or absorbing pattern (e.g. grooves obtained by etching or cutting) may be provided between adjacent detector assemblies in order to reduce cross-talk. Additionally, in this case the electrical connectors 641 may pass through the scintillator layer, preferably in the reflecting or absorbing portion between adjacent detector assemblies. Furthermore, in this case, the scintillator layer may comprise apertures in the layer for the primary sub-beams, preferably wherein the apertures are coated with a conductive layer. It will be noted that the integral scintillator may be particularly beneficial for providing the array wherein the detector assemblies are provided to the side of the primary sub-beams because in this case, the electrical connectors 641 may be easily provided to the side of the integral scintillator and there is no need to form apertures for the passage of the sub-beams therethrough.

Additionally or alternatively, the charge based element 620 of each detector assembly 600 may be in a common charged based layer of the body. Thus, the body may comprise a charge detector layer comprising the plurality of charge based elements.

Additionally or alternatively, the photon detector 611 of each detector assembly 600 may be in a common photon detector layer. The photon detector layer may be part of the main body. Thus, the body may comprise a photon detector layer comprising the plurality of photon detector elements. Alternatively, the photon detector layer may be spaced apart from the main body of the detector arrangement, i.e. forming a remote photon detector layer. For example, each photon detector may be optically connected to a respective scintillator element. The remote photon detectors may be provided in a remote common photon detector layer.

Additionally or alternatively, the reflective element 630 between the charge based element and the scintillator element of each detector assembly may be in a common reflective element layer of the body. Thus, the body may further comprise an reflective element 630 between the charge based elements and the scintillator elements.

Additionally or alternatively, the circuitry layer 640 of each detector assembly may be comprised in a common circuitry layer of the body. Thus, the circuitry layer may comprise a plurality of cells comprising circuitry associated with the charge based elements and/or the photon detectors as for example described and depicted in **FIGS. 10A**, **10B and 10C**. The detector assembly 600 may comprise one or more electrical connectors for each cell, electrically connecting the respective charge based element 620 and/or the respective scintillator element 610 to the circuitry of the cell. For example, each of the charge based elements 620 may comprise an electrical connector 641 as described above, which is connected from a respective one of the charge based elements 620 to the circuitry layer 640. Each of the photon detectors 611 may additionally or alternatively comprise an electrical connector to electrically connect to the detector circuitry, or the photon detectors 611 may be directly connected to the detector circuitry.

More generally, the detector arrangement may comprise one or more electrical connectors for each cell, connecting the respective charged based element and/or the photon detector to the circuitry of the cell. The electrical connectors are used to provide electrical communication between the respective charged based element and/or the photon detector to the circuitry of the cell. The electrical connector may be provided in the form of the electrical connector described above, and/or a wired connection.

The circuitry layer 640 may comprise a transimpedance amplifier and/or an analog-to-digital converter in each cell. Optionally, the circuitry layer may comprise a transimpedance amplifier and/or an analog-to-digital converter for each of the respective charged based element 620 and/or the respective photon detector 611 of the corresponding cell.

In other words, the detector arrangement may comprise an amplification circuit associated with each photon detector and proximate to the corresponding photon detector, the amplification circuit comprising a Trans Impedance Amplifier and/or an analogue to digital converter. Thus, each of the charge based elements 620 and/or the photon detectors 611 may be connected to a transimpedance amplifier and/or an analog-to-digital converter associated with the respective charge based element and/or the photon detectors 611.

The detector arrangement may further comprise a wiring layer. The wiring may be routed between cells. Thus, the wiring layer may include the wiring routes 554 described above. The wiring layer may connect to the circuitry of a cell (e.g. relating to a single photon detector and a single charge based element) away from the apertures, e.g. defined through the cell array as described above. The wiring layer may comprise shielding between wiring connecting different cells. For example, the wiring layer may comprise a shielding arrangement as shown in and described above in relation to **FIG. 13.** The cells may only be connected to each other via the wiring of the wiring layer. The wiring layer may be formed between and around the cells. The wiring layer and the circuitry layer may form a single layered portion together. (Within the layered portion, the wiring and circuitry may take up as many of the CMOS layers as the CMOS architecture permits). Alternatively the wiring layer and the circuitry layer may each have their own respective layered portion. The wiring layer may form a connection for a cell in between the cells of the cell array. The wiring layer may externally connect a cell so that the detection signal of a detector assembly may be transmitted from a cell to an external connection towards a processor for processing detection signal. The circuits and wiring of each cell are generally isolated; that is the cells are electrically insulated from each other. The wiring layer connects the associated detector to a data path for transmitting detection signals from the detector arrangement in a manner which reduces the risk of disruption to the detection signal. The wires for transporting the detection signal externally are isolated to prevent cross-talk. The wiring layer and/or the circuitry layer may form, for example separately or together, a monolithic layered portion in the substrate configured to connect to each of the detector assemblies in the detector arrangement.

As described above in relation to the single detector assemblies, the charge based element 620 may be closer to the detection surface. Thus, the charge detector layer may be closer to the detection surface of the detector arrangement than the corresponding scintillator element layer. Each of the charge based elements 620 may overlap with at least part of the corresponding scintillator element 610. In an embodiment, the overlap is substantially complete, as shown in **FIGS.14 to 17.** Thus, the array may be provided based on the detector assembly as shown in **FIG. 14.** In another embodiment, there may only be a partial overlap of the charge based element. In this case, the detection surface may be provided by the charge detector layer and the scintillator detector layer (and/or the reflective element 630 if provided).

Any of the detector assemblies and/or detector arrangements described above may be provided as part of a charged particle device for an assessment tool to detect charged particles from a sample.

The charged particle device may be a single beam device, for example as described in relation to **FIG. 9,** although other configurations may be used for the provision of a single beam device. The charged particle device may comprise an objective lens (e.g. of objective lens assembly 132) configured to project the primary beam of charged particles onto the sample 208. The objective lens may be configured as described above. Preferably, an aperture is defined in the objective lens for the primary beam and an aperture is defined in the detector assembly 600 which is aligned with the aperture in the objective lens. Although as described above, the detector assembly 600 could be provided to the side of the primary beam, such that the detector assembly does not have an aperture formed through the detector assembly 600. In this case, the detector assembly 600 may still be aligned with the primary beam, e.g. by being positioned in the charged particle device in close proximity to the primary beam so as to detect signal particles emitted from the sample. The detector assembly used in the charged particle device may be as described in any of the above embodiments and variations.

The charged particle device may comprising an objective lens configured to project the charged particle beam onto a sample and a detector assembly comprising at least a scintillator element and a photon detector as described above. The detector assembly, and preferably the scintillator element and/or photon detector, may be positioned in the path of the charged particle sub-beam. An aperture is preferably defined in the objective lens for the charged particle beam and an aperture is defined in the detector assembly for the charged particle beam. Thus, the scintillator element and/or the photon detector may define apertures through which the charged particle beam can pass. The charge based element may optionally be provided as in any of the above described variations.

The charged particle device may be a multi-beam device, for example as described in relation to **FIGS. 3 and 8,** although other configurations may be used for the provision of a multi-beam device. The charged particle device may comprise an objective lens array 241 configured to project a plurality of sub-beams of charged particles onto the sample 208 in a multi-beam array. The objective lens array 241 may be configured as described above. The charged particle device may comprise a detector arrangement as described in any of the above embodiments or variations, or an array of detector assemblies as described in any of the above embodiments or variations.

The detector arrangement may be positioned in the path of the charged particle beams. For example, the detection surfaces of the detector arrangement may be substantially orthogonal to the path of the sub-beams. For example, the detector arrangement may be positioned such that the sub-beams pass through, or adjacent to the detector assemblies of the arrangement. For example, the detector arrangement in the path of the charged particle beams may comprise an array of scintillator elements and an array of photon detectors, preferably wherein the array of scintillator elements corresponds to the array of photon detectors so that each scintillator has an associated photon detector. Preferably, the detector arrangement may further comprise an array of charge based elements, wherein each charge based element is positioned so that at least some of the signal particles above the energy threshold pass through the charged based element to a respective scintillator element for detection by the respective scintillator element.

Preferably, an aperture is defined in the objective lens array for each of the sub-beams and an aperture is defined in each of the detector assemblies of the detector arrangement. Preferably the apertures of the at least one detector arrangement are aligned with the apertures defined in the objective lens array 241. Thus, there may be corresponding arrays of objective lens apertures and detector arrangement apertures for the passage of the array of sub-beams. Each aperture may correspond (i.e. provide passage) for a single sub-beam, or groups of sub-beams. Preferably, in each scintillator element and/or in each associated photon detector and/or in each associated charge based element (depending on which components are provided) is defined an aperture for a respective sub-beam, or a group of sub-beams, preferably one or more rows for example across an arrangement of the sub-beams.

The detector assembly 600 may be associated with the objective lens array 241. For example, the detector assembly 600 may be structurally connected to the objective lens array 241. Thus, the detector assembly 600 may be positioned on, attached, or directly connected to the objective lens. Specifically, the detector assembly 600 may be associated with a major surface of an electrode plate of the objective lens array 241. Thus, the detector assembly 600 may be structurally connected to an electrode of the objective lens array 241. The detector assembly 600 may be positioned adjacent to, or structurally connected to the most down-beam electrode of the objective lens array 241. The detector assembly 600 may be positioned adjacent to, or structurally connected to, a down-beam surface of the most down-beam electrode of the objective lens array 241. The detector assembly 600 could be positioned adjacent to, or structurally connected to, the most up-beam electrode of the objective lens array 241. If the detector assembly 600 is part of the detector arrangement, the detector arrangement may be associated with the objective lens array 241 as described herein.

The detector assembly 600 may be positioned in any appropriate location in the charged particle device, e.g. as described above in relation to **FIG. 7.** The detector assembly 600 may provide a surface of the device. Preferably the surface of the device is configured to face the sample. Preferably the detector assembly 600 is proximate the sample. Preferably the detector assembly 600 is adjacent the sample. Preferably the detector assembly 600 is directly adjacent the sample and there are no other components between the detector assembly 600 and the sample. It is beneficial to provide the detector assembly 600 proximate the sample because this improves overall detection efficiency of the lower and higher energy signal particles simultaneously at the detector elements. The detector assembly 600 could be provided up-beam of the objective lens array 241 along the path of the primary beam 320 (e.g. positioned as shown in relation to the above-lens array of detectors 380 in **FIG. 7**). If the detector assembly 600 is part of the detector arrangement, the detector arrangement may be positioned as described herein.

The device may be configured to apply a potential difference between the sample 208 and the detector arrangement (if the assemblies are provided in an array). The potential difference may be referred to as a bias voltage. For example, the potential may be relatively small. For example, the potential difference between the sample 208 and the detector arrangement may be approximately 100 V or less. For example, the potential difference between the sample 208 and the detector arrangement may be approximately >0V - 300 V, or preferably 50 V-300 V. The detector arrangement may be more positive than the sample. Thus, the potential difference may be used to attract signal particles to the detector arrangement. Such an accelerating voltage (e.g. around 50 V - 300V) is small compared the difference in energy between lower energy signal particles (e.g. secondary signal particles with a maximum energy of approximately 50 eV) and higher energy signal particles (e.g. backscatter signal particles with a maximum energy up to the landing energy of keV's or more). It will be noted that a small potential difference will tend to have a greater effect on the lower energy particles, such as those corresponding to the secondary signal particles. Of course, the same potential may be applied to a single detector assembly, e.g. when provided as part of a single beam device.

The present invention may also provide a method of detecting signal particles using any of the detector assemblies, detector arrangements, or charged particle devices as described above.

In an embodiment, a method is provided of projecting a beam of charged particles onto a sample so as to detect signal particles emitted from the sample, the method comprising: a) projecting the beam along a primary beam path onto a surface of the sample; and b) simultaneously generating photons at a scintillator element on interaction with signal particles above a first energy threshold and detecting signal particles below a second energy threshold at a charge based element, preferably wherein the detecting and generating occurring in the same detector assembly comprising the charged based element and the scintillator element.

In an embodiment, a method is provided of projecting a beam of charged particles onto a sample so as to detect signal particles emitted from the sample, the method comprising: a) projecting the beam along a primary beam path through an aperture of a detector assembly onto a surface of the sample, wherein the detector assembly comprises a scintillator element and a photon detector; and b) generating photons on interaction with signal particles emitted from the sample at the scintillator and detecting the photons generated by the scintillator element at the photon detector.

In an embodiment, a method is provided of projecting a plurality of charged particle sub-beams onto a sample so as to detect signal particles emitted from the sample in response to the primary sub-beams, the method comprising: a) projecting the charged particle beams along primary sub-beam paths onto a surface of the sample; and b) simultaneously generating photons on interaction with signal particles above a first energy threshold at a respective scintillator element and detecting signal particles below a second energy threshold at a respective charge based element, preferably wherein the detecting and generating occur in the same detector assembly comprising the charged based element and the scintillator element.

In an embodiment, a method is provided of projecting a plurality of charged particle sub-beams onto a sample so as to detect signal particles emitted from the sample, the method comprising: a) projecting the charged particle sub-beams along primary beam paths through at least one aperture of a detector arrangement onto a surface of the sample, wherein the detector arrangement comprises scintillator elements and photon detectors, preferably a respective scintillator element and a respective photon detector for each corresponding sub-beam; and b) generating photons on interaction with signal particles emitted from the sample in response to a sub-beam at the respective scintillator elements and detecting the photons generated by the respective scintillator elements at the respective photon detectors preferably wherein the generating and optionally the detecting occurs in a detector assembly located in the path of an arrangement of the plurality of charged particle sub-beams.

In an embodiment, a method is provided of projecting a plurality of charged particle beams onto a sample so as to detect signal particles emitted from the sample, the method comprising: a) projecting the beams along primary beam paths onto a surface of the sample; and b) detecting the signal particles emitted from the sample at a detector arrangement, the detector arrangement comprising: an array of scintillator elements configured to generate photons on interaction with signal particles above an energy threshold; an array of photon detectors configured to detect photons generated by the scintillator elements; and an amplification circuit associated with each photon detector and proximate to the corresponding photon detector, the amplification circuit comprising a Trans Impedance Amplifier and/or an analogue to digital converter.

In the present description, it will be understood that the charged particles/signal particles are generally intended to be electrons, or other negatively charged particles. However, contrary to the above, the charged particles/signal particles may be positively charged particles, e.g. ions. Thus, a primary ion beam may be provided. With a primary ion beam, secondary ions could be emitted from the sample that could be detected by the charge based element 620. However, this would also generate negative charged particles, e.g. secondary electrons at the same time. So the charge accumulated with this charge based element 620 will be a mix of positively and negatively charged particles, which would make the charged measurement unreliable. However, having either a positive or negative bias on the charge based element 620 would make it possible to choose one of the charge polarities. Because of the much smaller range of ions than electrons in a material, backscatter ions need a much larger kinetic energy to be able to reach the scintillator element 610. Thus, not all backscatter ions will make it to this detector component. To improve the detection of backscatter ions, the charge based element 620 could be made thinner. In the instance that ions are used instead of negatively charged particles, then any bias referred to above would be opposite, e.g. a positive bias should be used instead of a negative one and vice versa.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons. The charged-particle optical device may be a negative charged particle device. The charged-particle optical device may otherwise be referred to as an electron-optical device. It will be understood that an electron is a specific charged particle and can replace all instances of charged particle referred to throughout the application as appropriate. For example, the source may specifically provide electrons. The charged particle referred to throughout the specification may be specifically a negatively charged particle.

The charged particle-optical device may more specifically be defined as a charged particle-optical column. In other words, the device may be provided as a column. The column may thus comprise an objective lens array assembly as described above. The column may thus comprise a charged particle optical system as described above, for example comprising an objective lens array and optionally a detector array and/or optionally a condenser lens array.

The charged particle optical device described above comprises at least the objective lens array 240. The charged particle optical device may comprise the detector array 241. The charged particle optical device may comprise the control lens array 250. The charged particle optical device comprising the objective lens array and the detector array may thus be interchangeable with, and referred to as, the objective lens array assembly, which may optionally comprise the control lens array 250. The charged particle optical device may comprise additional components described in relation to either of **FIG. 3 and/or FIG. 8.** Thus, the charged particle optical device may be interchangeable with, and referred to as, a charged particle assessment tool 40 and/or an charged particle optical system if comprising the additional components in these figures.

An assessment tool according to an embodiment of the invention may be a tool which makes a qualitative assessment of a sample (e.g. pass/fail), one which makes a quantitative measurement (e.g. the size of a feature) of a sample or one which generates an image of map of a sample. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam tool 40 (which may be a charged particle -optical column) may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, the condenser lens 231, correctors, collimator element array 271 and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or charged particle-optical elements arranged in arrays along a beam or a multi-beam path. Such charged particle-optical elements may be electrostatic. In an embodiment all the charged particle-optical elements, for example from a beam limiting aperture array to a last charged particle-optical element in a sub-beam path before a sample, may be electrostatic and/or may be in the form of an aperture array or a plate array. In some arrangements one or more of the charged particle-optical elements are manufactured as a microelectromechanical system (MEMS) (i.e. using MEMS manufacturing techniques).

The system or device of such architectures as depicted in at least **FIGS. 3 and 8** and as described above may comprise components such as an upper beam limiter, a collimator element array 271, a control lens array 250, a scan deflector array 260, an objective lens array 241, a beam shaping limiter and/or a detector array 240; one or more of these elements that are present may be connected to one more adjacent elements with an isolating element such as a ceramic or glass spacer.

A computer program may comprise instructions to instruct the controller 50 to perform the following steps. The controller 50 controls the charged particle beam apparatus to project a charged particle beam towards the sample 208. In an embodiment the controller 50 controls at least one charged particle-optical element (e.g. an array of multiple deflectors or scan deflectors 260, 265) to operate on the charged particle beam in the charged particle beam path. Additionally or alternatively, in an embodiment the controller 50 controls at least one charged particle-optical element (e.g. the detector array 240) to operate on the charged particle beam emitted from the sample 208 in response to the charged particle beam.

Any element or collection of elements may be replaceable or field replaceable within the charged particle beam tool 40. The one or more charged particle-optical components in the charged particle beam tool 40, especially those that operate on sub-beams or generate sub-beams, such as aperture arrays and manipulator arrays may comprise one or more MEMS.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There are provided the following clauses:

Clause 1: A detector assembly for use in a charged particle device for an assessment tool to detect signal particles emitted by a sample in response to a charged particle beam, the detector assembly comprising: a scintillator element configured to generate photons on interaction with signal particles above a first energy threshold; a charge based element configured to detect signal particles below a second energy threshold, wherein the charge based element is positioned so that at least some of the signal particles above a first energy threshold pass through the charged based element to the scintillator element.

Clause 2: The detector assembly of clause 1, further comprising a photon guiding element configured to transport photons generated by the scintillator element away from the scintillator element, preferably wherein the photons are transported to a photon detector remote from the scintillator element, optionally external to the detector assembly, preferably the photon guiding element comprises optic fibre.

Clause 3: The detector assembly of clause 1 or 2, further comprising a photon detector configured to detect photons generated by the scintillator element.

Clause 4: The detector assembly of clause 3, wherein the photon detector is directly connected to the scintillator element.

Clause 5: The detector assembly of either one of clauses 3 or 4, wherein the photon detector is positioned up beam of at least part of a surface of the scintillator element to receive the generated photons.

Clause 6: The detector assembly of any one of clauses 3 to 5, wherein the photon detector is connected to detector circuitry that is preferably comprised in a circuitry layer.

Clause 7: The detector assembly of any one of clauses 3 to 6, wherein photon detector is in electrical communication, preferably electrically connected, to a transimpedance amplifier and/or an analogue to digital converter preferably in a circuitry layer.

Clause 8: The detector assembly of any one of clauses 3 to 7, wherein the photon detector comprises zoned portions, comprising an inner photon portion and an outer photon portion which are preferably concentric and radially divided from each other.

Clause 9: The detector assembly of any one of clauses 3 to 8, wherein the photon detector comprises zoned portions which are sectors, preferably angularly divided from each other and/or wherein the scintillator element comprises zoned portions which are sectors, preferably angularly divided from each other, preferably wherein the zoned portions of the scintillator element correspond to the zoned portions of the photon detector.

Clause 10: The detector assembly of any one of clauses 3 to 9, wherein an aperture is defined in the photon detector for the passage therethrough of the charged particle beam.

Clause 11: The detector assembly of any preceding clause, wherein an aperture is defined in the scintillator element and/or the charge based element for the passage therethrough of the charged particle beam.

Clause 12: The detector assembly of any preceding clause, wherein the charge based element and the scintillator element are each at least part of layers that are substantially co-planar with the major surfaces of the detector assembly and the layers are stacked in a thickness direction of the detector assembly.

Clause 13: The detector assembly of any preceding clause, wherein the charge based element is positioned down beam of the scintillator element.

Clause 14: The detector assembly of any preceding clause, wherein the charge based element comprises a metal layer.

Clause 15: The detector assembly of any preceding clause, wherein the charge based element is in electrical communication with detector circuitry that is preferably comprised in a circuitry layer.

Clause 16: The detector assembly of any preceding clause, wherein the charge based element is closer to a detection surface than the scintillator element.

Clause 17: The detector assembly of any preceding clause, a detection surface of the detection assembly preferably configured to face the sample, wherein the charged based element provides at least part of the detection surface, preferably substantially the whole detection surface.

Clause 18: The detector assembly of any preceding clause, wherein the charge based element has a thickness of approximately 100 nm or less, preferably approximately 10 nm to 100 nm.

Clause 19: The detector assembly of any preceding clause, wherein the charged based element is connected to a transimpedance amplifier and/or an analogue to digital converter preferably in a circuitry layer.

Clause 20: The detector assembly of any preceding clause, wherein the scintillator element comprises a photon reflection surface configured to reflect photons with an elevated efficiency, preferably the photon reflection surface is a surface of the scintillator element treated to improve photon reflection in the scintillator element.

Clause 21: The detector assembly of any preceding clause, wherein the scintillator element comprises organics.

Clause 22: The detector assembly of any one of clauses 1 to 21, wherein the scintillator element comprises inorganics.

Clause 23: The detector assembly of any preceding clause, further comprising a light shield positioned so as to shield at least part of the scintillator element to prevent stray light from the scintillator reaching the photo detector.

Clause 24: The detector assembly of any preceding clause, further comprising a reflective layer positioned over at least a portion of the scintillator element.

Clause 25: The detector assembly of clause 24, wherein the reflective layer is at least between the scintillator element and the charge based element.

Clause 26: The detector assembly of clause 24 or 25, wherein the reflective layer comprises thin tape, thin foils and/or reflective paint.

Clause 27: The detector assembly of any of clauses 24 to 26, wherein the charge based element is positioned over the reflective layer, preferably the charged based element providing the detection surface of the detector assembly.

Clause 28: The detector assembly of any preceding clause, wherein the first energy threshold corresponds to a backscatter threshold energy.

Clause 29: The detector assembly of any preceding clause, wherein the second energy threshold corresponds to a secondary threshold energy.

Clause 30: The detector assembly of any preceding clause, wherein the first energy threshold and the second energy threshold are substantially the same or have an offset, preferably wherein the first energy threshold is larger than the second energy threshold.

Clause 31: A detector arrangement for use in a multi-beam charged particle device for an assessment tool to detect signal particles emitted by a sample in response to a plurality of charged particle beams, the detector arrangement comprising an array of detector assemblies according to any one of clauses 1 to 30, wherein each detector assembly corresponds to a respective charged particle beam.

Clause 32: The detector arrangement of clause 31, further comprising: an array of photon detectors configured to detect photons generated by the scintillator elements; and an amplification circuit associated with each photon detector and proximate to the corresponding photon detector, the amplification circuit comprising a Trans Impedance Amplifier and/or an analogue to digital converter.

Clause 33: A detector arrangement for use in a multi-beam charged particle device for an assessment tool to detect charged particles emitted by a sample in response to a plurality of charged particle beams on the sample, the detector arrangement comprising: an array of scintillator elements configured to generate photons on interaction with signal particles above an energy threshold; an array of photon detectors configured to detect photons generated by the scintillator elements; and an amplification circuit associated with each photon detector and proximate to the corresponding photon detector, the amplification circuit comprising a Trans Impedance Amplifier and/or an analogue to digital converter.

Clause 34: The detector arrangement of clause 33, further comprising an array of charge based elements configured to detect signal particles below a second energy threshold, wherein each charge based element is positioned so that at least some of the signal particles above the energy threshold pass through the charged based element to a respective scintillator element.

Clause 35: The detector arrangement of any one of clauses 31 to 34, wherein the photon detectors are in a common photon detector layer.

Clause 36: The detector arrangement of any one of clauses 31 to 35, wherein the charge based element of each detector assembly is in a common charged based layer.

Clause 37: The detector arrangement of any one of clauses 31 to 36, wherein the circuitry layer of each detector assembly is comprised in a common circuitry layer.

Clause 38: The detector arrangement of any one of clauses 31 to 37, wherein the scintillator elements are arranged in an array corresponding in arrangement to the array of charged particle beams, wherein the arrangement may be a hexagonal or rectilinear grid.

Clause 39: The detector arrangement of any one of clauses 31 to 38, wherein scintillator elements and/or photon detectors and/or charge based elements comprise apertures for the passage of a respective charged particle beam or a group of charged particle beams.

Clause 40: The detector arrangement of any one of clauses 31 to 39, further comprising a circuitry layer comprising a plurality of cells comprising circuitry associated with the charged based element and/or the photon detector.

Clause 41: The detector arrangement of clause 40, further comprising one or more electrical connectors for each cell, connecting the respective charged based element and/or the photon detector to the circuitry of the cell.

Clause 42: The detector arrangement of either of clauses 40 or 41, wherein the circuitry layer comprises a transimpedance amplifier and/or an analog-to-digital converter in each cell, optionally for each of the respective charged based element and/or the respective photon detector of the corresponding cell.

Clause 43: The detector arrangement of any one of clauses 40 to 42, wherein further comprising a wiring layer, wherein the wiring layer comprises wiring that connects the circuitry of the cell away from the plurality of apertures

Clause 44: The detector arrangement of clause 43, wherein the wiring is routed between cells.

Clause 45: The detector arrangement of either of clauses 43 or 44, wherein the wiring comprises shielding between wiring connecting different cells.

Clause 46: A charged particle device for an assessment tool to detect signal particles emitted by a sample in response to a charged particle beam, the device comprising: an objective lens configured to project the charged particle beam onto the sample; and a detector assembly according to any one of clauses 1 to 30.

Clause 47: The charged particle device of clause 46, wherein an aperture is defined in the objective lens for the charged particle beam and an aperture is defined in detector assembly for the charged particle beam.

Clause 48: The charged particle device of either one of clauses 46 or 47, wherein detector comprises a photon detector configured to detect photons generated by the scintillator element.

Clause 49: A charged particle device for an assessment tool to detect signal particles emitted by a sample in response to a charged particle beam, the device comprising: an objective lens configured to project the charged particle beam onto a sample, wherein an aperture is defined in the objective lens for the charged particle beam; and a detector assembly comprising a scintillator element configured to generate photons on interaction with signal particles and a photon detector configured to detect photons generated by the scintillator element, wherein an aperture is defined in the detector assembly for the charged particle beam.

Clause 50: The charged particle device of clause 49, further comprising a charge based element configured to detect signal particles below a second energy threshold, wherein the charge based element is positioned so that the signal particles above a first energy threshold pass through the charged based element to the scintillator element.

Clause 51: The charged particle device of any one of clauses 46 to 50, wherein the detector assembly is structurally connected to the objective lens.

Clause 52: The charged particle device of any one of clauses 46 to 51, wherein the detector assembly is associated with a major surface of an electrode plate of the objective lens.

Clause 53: The charged particle device of any one of clauses 46 to 52, wherein the detector assembly provides a surface of the device, preferably configured to face a sample and/or such that the detector assembly is proximate the sample.

Clause 54: The charged particle device of any one of clauses 46 to 53, wherein the detector assembly is provided up beam along the path of the plurality of beams of the objective lens.

Clause 55: A charged particle device for an assessment tool to detect signal particles emitted by a sample in response to a plurality of charged particle beams, the device comprising: an objective lens array configured to project a plurality of charged particle beams onto a sample in a multi-beam array; and a detector arrangement of any one of clauses 31 to 45.

Clause 56: The charged particle device of clause 55, wherein the detector arrangement is in the path of the charged particle beams, and the detector arrangement further comprises an array of photon detectors configured to detect photons generated by the scintillator elements.

Clause 57: A charged particle device for an assessment tool to detect signal particles emitted by a sample in response to a plurality of charged particle beams, the device comprising: an objective lens array configured to project a plurality of charged particle beams onto a sample in a multi-beam array; and a detector arrangement in the path of the charged particle beams, the detector arrangement comprising an array of scintillator elements configured to generate photons on interaction with signal particles above an energy threshold; and an array of photon detectors configured to detect photons generated by the scintillator elements, preferably the array of scintillator elements corresponds to the array of photon detectors so that each scintillator has an associated photon detector.

Clause 58: The charged particle device of clause 57, further comprising an array of charge based elements configured to detect signal particles below a second energy threshold, wherein each charge based element is positioned so that at least some of the signal particles above the energy threshold pass through the charged based element to a respective scintillator element for detection by the respective scintillator element.

Clause 59: The charged particle device of any one of clauses 55 to 58, wherein in each scintillator element and/or in each associated photon detector and/or in each associated charge based element is defined an aperture for a respective charged particle beam, or a group of charged particle beams, preferably one or more rows for example across an arrangement of the charged particle beams.

Clause 60: The charged particle device of clause 59, wherein the apertures are aligned with the apertures defined in the objective lens array.

Clause 61: The charged particle device of any one of clauses 55 to 60, wherein the detector arrangement is structurally connected to the objective lens.

Clause 62: The charged particle device of any one of clauses 55 to 61, wherein the detector arrangement is associated with a major surface of an electrode plate of the objective lens.

Clause 63: The charged particle device of any one of clauses 55 to 62, wherein at least one detector assembly of the detector arrangement provides a surface of the device, preferably configured to face a sample and/or such that the detector is proximate the sample.

Clause 64: The charged particle device of any one of clauses 55 to 62, wherein at least one detector assembly of the detector arrangement is provided up beam along the path of the plurality of beams of the objective lens.

Clause 65: The charged particle device of any one of clauses 46 to 64, wherein the device is configured to apply a potential difference between the sample and the detector.

Clause 66: The charged particle device of clause 65, wherein the potential difference between the sample and the detector is approximately 50 V-300 V.

Clause 67: The charged particle device of clause 66, wherein the detector is more positive than the sample.

Clause 68: A method of projecting a beam of charged particles onto a sample so as to detect signal particles emitted from the sample, the method comprising: a) projecting the beam along a primary beam path onto a surface of the sample; and b) simultaneously generating photons at a scintillator element on interaction with signal particles above a first energy threshold and detecting signal particles below a second energy threshold at a charge based element, preferably wherein the detecting and generating occurring in the same detector assembly comprising the charged based element and the scintillator element.

Clause 69: A method of projecting a beam of charged particles onto a sample so as to detect signal particles emitted from the sample, the method comprising: a) projecting the beam along a primary beam path through an aperture of a detector assembly onto a surface of the sample, wherein the detector assembly comprises a scintillator element and a photon detector; and b) generating photons on interaction with signal particles emitted from the sample at the scintillator and detecting the photons generated by the scintillator element at the photon detector.

Clause 70: A method of projecting a plurality of charged particle sub-beams onto a sample so as to detect signal particles emitted from the sample in response to the primary sub-beams, the method comprising: a) projecting the charged particle beams along primary sub-beam paths onto a surface of the sample; and b) simultaneously generating photons on interaction with signal particles above a first energy threshold at a respective scintillator element and detecting signal particles below a second energy threshold at a respective charge based element, preferably wherein the detecting and generating occur in the same detector assembly comprising the charged based element and the scintillator element.

Clause 71: A method of projecting a plurality of charged particle sub-beams onto a sample so as to detect signal particles emitted from the sample, the method comprising: a) projecting the charged particle sub-beams along primary beam paths through at least one aperture of a detector arrangement onto a surface of the sample, wherein the detector arrangement comprises scintillator elements and photon detectors, preferably a respective scintillator element and a respective photon detector for each corresponding sub-beam; and b) generating photons on interaction with signal particles emitted from the sample in response to a sub-beam at the respective scintillator elements and detecting the photons generated by the respective scintillator elements at the respective photon detectors preferably wherein the generating and optionally the detecting occurs in a detector assembly located in the path of an arrangement of the plurality of charged particle sub-beams.

Clause 72: A method of projecting a plurality of charged particle beams onto a sample so as to detect signal particles emitted from the sample, the method comprising: a) projecting the beams along primary beam paths onto a surface of the sample; and b) detecting the signal particles emitted from the sample at a detector arrangement, the detector arrangement comprising: an array of scintillator elements configured to generate photons on interaction with signal particles above an energy threshold; an array of photon detectors configured to detect photons generated by the scintillator elements; and an amplification circuit associated with each photon detector and proximate to the corresponding photon detector, the amplification circuit comprising a Trans Impedance Amplifier and/or an analogue to digital converter.

**Claims**

1. A detector assembly for use in a charged particle device for an assessment tool to detect signal particles emitted by a sample in response to a charged particle beam, the detector assembly comprising:

   a scintillator element configured to generate photons on interaction with signal particles above a first energy threshold;
   a charge based element configured to detect signal particles below a second energy threshold, wherein the charge based element is positioned so that at least some of the signal particles above a first energy threshold pass through the charged based element to the scintillator element.

2. The detector assembly of claim 1, further comprising a photon detector configured to detect photons generated by the scintillator element.

3. The detector assembly of claim 2, wherein the photon detector is directly connected to the scintillator element.

4. The detector assembly of either of claims 2 or 3, wherein the photon detector is positioned up beam of at least part of a surface of the scintillator element to receive the generated photons.

5. The detector assembly of any of claims 2 to 4, wherein the photon detector is connected to detector circuitry that is preferably comprised in a circuitry layer.

6. The detector assembly of any of claims 2 to 5, wherein the photon detector comprises zoned portions, comprising an inner photon portion and an outer photon portion which are preferably concentric and radially divided from each other.

7. The detector assembly of any of claims 2 to 6, wherein an aperture is defined in the photon detector for the passage therethrough of the charged particle beam.

8. The detector assembly of any preceding claim, wherein an aperture is defined in the scintillator element and/or the charge based element for the passage therethrough of the charged particle beam.

9. The detector assembly of any preceding claim, wherein the charge based element and the scintillator element are each at least part of layers that are substantially co-planar with the major surfaces of the detector assembly and the layers are stacked in a thickness direction of the detector assembly.

10. The detector assembly of any preceding claim, wherein the charge based element is positioned down beam of the scintillator element.

11. The detector assembly of any preceding claim, wherein the charge based element is closer to a detection surface than the scintillator element.

12. The detector assembly of any preceding claim, a detection surface of the detection assembly preferably configured to face the sample, wherein the charged based element provides at least part of the detection surface, preferably substantially the whole detection surface.

13. The detector assembly of any preceding claim, wherein the first energy threshold corresponds to a backscatter threshold energy and/or wherein the second energy threshold corresponds to a secondary threshold energy.

14. The detector assembly of any preceding claim, wherein the first energy threshold and the second energy threshold are substantially the same or have an offset, preferably wherein the first energy threshold is larger than the second energy threshold.

15. A detector arrangement for use in a multi-beam charged particle device for an assessment tool to detect signal particles emitted by a sample in response to a plurality of charged particle beams, the detector arrangement comprising an array of detector assemblies according to any of claims 1 to 14, wherein each detector assembly corresponds to a respective charged particle beam.

# Fig. 1

# Fig. 2

# Fig. 3

# Fig. 4

Fig. 5

EP 4 117 015 A1

# Fig. 6A

405

405A

406

405B

# Fig. 6B

405F

405C

406

405E

405D

405

# Fig. 7

320

320

380

241

242

370

245

350

243

405B

405A

208

405A

405B

405A

246

# Fig. 8

## Fig. 9

Fig. 10A

Fig. 10B

Fig. 10C

# Fig. 11

# Fig. 12

# Fig. 13

# Fig. 14

600

612    611

320

611    640

601

641

610

610

620

613

630

208

# Fig. 15

600

640    611B

320

611B    640

601

641

611A

611A

641

610A

610A

610B

610B

610B

610B

630    620

620    630

208

## Fig. 16

600

740
711
320
601
650
740
711
650
640
650
650
640
610
610
620
630
620
630
208

## Fig. 17

600

611
640
320
601
611
640
660
660
641
610
610
641
620
630
620
630
620
208

Europäisches Patentamt
European Patent Office
Office européen des brevets

## EUROPEAN SEARCH REPORT

Application Number

EP 21 18 3803

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 872 873 A2 (HITACHI LTD [JP]) 21 October 1998 (1998-10-21) | 1-5,7-14 | INV. H01J37/244 H01J37/317 |
| Y | * column 9, lines 17-56; figures 3,11,13 * * column 6, lines 19-40 * * column 17, lines 4-9; figures 9,10 * | 6,15 | |
| Y | "SYSTEMS AND METHODS FOR SIGNAL ELECTRON DETECTION", RESEARCH DISCLOSURE, KENNETH MASON PUBLICATIONS, HAMPSHIRE, UK, GB, vol. 677, no. 30, 1 September 2020 (2020-09-01), page 2277, XP007148648, ISSN: 0374-4353 [retrieved on 2020-08-06] * paragraphs [0082], [0083], [0100], [0102]; figures 3A,7A * * line 36, paragraph 5 * * line 11, paragraph 6 * | 6 | |
| Y | "SEMICONDUCTOR CHARGED PARTICLE DETECTOR FOR MICROSCOPY", RESEARCH DISCLOSURE, KENNETH MASON PUBLICATIONS, HAMPSHIRE, UK, GB , vol. 685, no. 82 1 May 2021 (2021-05-01), XP007149412, ISSN: 0374-4353 Retrieved from the Internet: URL:ftp://ftppddoc/RDData685_EPO.zip Pdf/685082.pdf * paragraphs [0079], [0138] – [0140]; figures 2B,3G,11,12 * | 15 | TECHNICAL FIELDS SEARCHED (IPC) H01J |

The present search report has been drawn up for all claims

| Place of search | Date of completion of the search | Examiner |
|---|---|---|
| Munich | 28 January 2022 | Chevrier, Dominique |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 18 3803

This annex lists the patent family members relating to the patent documents cited in the above-mentioned European search report.
The members are as contained in the European Patent Office EDP file on
The European Patent Office is in no way liable for these particulars which are merely given for the purpose of information.

28-01-2022

| Patent document cited in search report | | Publication date | Patent family member(s) | | Publication date |
|---|---|---|---|---|---|
| EP 0872873 | A2 | 21-10-1998 | EP | 0872873 A2 | 21-10-1998 |
| | | | JP | 3434165 B2 | 04-08-2003 |
| | | | JP | H10294074 A | 04-11-1998 |
| | | | KR | 19980081497 A | 25-11-1998 |
| | | | US | 5939720 A | 17-08-1999 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 20184161
- US 2020118784 A
- US 20200203116 A
- US 20190259570 A
- US 20190259564 A
- EP 1602121 A1
- EP 20156253
- EP 20207178
- EP 2702595 A1
- EP 2715768 A2
- US 20100276606 A
- EP 2425444 A
- EP 20216927
- EP 21174518